# EUROPEAN PATENT APPLICATION

(11) **EP 4 839 030 A1**
(43) Date of publication of application: **11.11.2026**
(21) Application number: 25741998.6
(22) Date of filing: 16.01.2025
(51) Int. Cl.: H05K 3/40, H05K 1/11

(54) **METHOD FOR MANUFACTURING SUBSTRATE WITH CONDUCTIVE VIA, SUBSTRATE WITH CONDUCTIVE VIA, METHOD FOR MANUFACTURING CIRCUIT BOARD WITH CONDUCTIVE VIA, AND CIRCUIT BOARD WITH CONDUCTIVE VIA**

(30) Priority: 17.01.2024 JP 2024005289; 31.01.2024 JP 2024013073
(71) Applicant: Resonac Corporation, Tokyo 105-7325 (JP)
(72) Inventor: EJIRI Yoshinori, Tokyo 105-7325 (JP); SAKAMOTO Masumi, Tokyo 105-7325 (JP); SHIMIZU Chiaki, Tokyo 105-7325 (JP); OIKAWA Futoshi, Tokyo 105-7325 (JP); URAGAMI Hiroshi, Tokyo 105-7325 (JP); KAI Seiji, Tokyo 105-7325 (JP); MORIJIRI Tomoki, Tokyo 105-7325 (JP); KIKUCHI Naoyuki, Tokyo 105-7325 (JP); URASHIMA Kosuke, Tokyo 105-7325 (JP); KURAHASHI Shunsuke, Tokyo 105-7325 (JP); NISHIMOTO Masayoshi, Tokyo 105-7325 (JP); YOKOZUMI Tomomi, Tokyo 105-7325 (JP); AKAI Kunihiko, Tokyo 105-7325 (JP)
(74) Representative: Hoffmann Eitle
(86) International application number: PCT/JP2025/001206
(87) International publication number: WO 2025/154773

(57) **Abstract**

An object is to provide a method for manufacturing a substrate with conductive vias capable of exhibiting a sufficiently low connection resistance value even after wiring formation and allowing the obtained wiring board to have excellent connection reliability. The method for manufacturing a substrate with conductive vias comprises: step S1 of preparing a substrate with a metal sintered body, the substrate comprising a substrate having holes opening on one or both main surfaces and a metal sintered body having a porous structure provided inside the holes, the metal sintered body being exposed at the openings of the holes; and step S2 of providing the metal sintered body with a resin-containing part containing a photosensitive resin composition or a cured product thereof. The method for manufacturing a substrate with conductive vias of the present invention is also useful as a technique for reducing the environmental burden due to plating.

## Description

### Technical Field

The present invention relates to a method for manufacturing a substrate with conductive vias, a substrate with conductive vias, a method for manufacturing a wiring board with conductive vias, and a wiring board with conductive vias.

### Background Art

In recent years, for the purpose of size reduction, functional enhancement, and integration of electronic equipment or components, attention has been paid to a three-dimensional mounting technique of electrically connecting silicon substrates that are disposed up and down via electrodes called through-silicon vias (TSVs) provided in a silicon substrate and laminating semiconductor chips in a vertical direction (height direction) at a high density. In addition, a method of electrically connecting glass substrates disposed up and down via electrodes called through-glass vias (TGVs) using a glass substrate instead of a silicon substrate has also been attracting attention.

As a technique for forming through-electrodes, for example, Patent Literature 1 discloses a method for manufacturing a semiconductor device having through-silicon vias, the method including a step of plating blind-vias formed in a silicon substrate with copper by electroplating using a specific copper plating solution. However, such a method has an environmental burden due to plating, and has a problem in terms of productivity because the work time is extended due to the need to perform plating while suppressing the deposition rate of the copper coating.

As another technique, a method is known in which a copper conductor paste containing copper powder, glass powder, an organic vehicle, and the like is filled into through-holes of a heat-resistant substrate and fired to form a copper conductor in the through-holes (see, for example, Patent Literature 2 below and the like).

In addition, Patent Literature 3 below proposes a method for manufacturing a substrate having through-silicon vias by forming a copper sintered body having a porous structure in through-vias formed in a silicon substrate, impregnating the copper sintered body with a curable resin composition, and further performing a resin curing step.

### Citation List

### Patent Literature

[Patent Literature 1] Japanese Unexamined Patent Publication No. 2019-16712
[Patent Literature 2] Japanese Unexamined Patent Publication No. 2010-108917
[Patent Literature 3] Japanese Patent No. 7226531

### Summary of Invention

### Technical Problem

In recent times, as silicon substrates and glass substrates have been reduced in size to comply with the miniaturization of electronic equipment or components, the inner diameters of through-holes have also been minimized, and it has become necessary to form conductive vias having sufficient conductivity even in such through-holes. In addition, wirings may be further provided on the surface of the substrate on which the conductive vias are formed by plating or the like, and in this case as well, the substrate is required to exhibit a sufficiently low connection resistance value.

In addition, recently, higher signal speeds, smaller substrates, and lower power consumption through shorter transmission distances have been pursued, and further improvement in connection reliability beyond conventional levels is required. Under such circumstances, the substrate with conductive vias on which the above-described wirings are formed (wiring board) is required not only to have excellent conductivity but also to have the characteristic that the connection resistance value is unlikely to increase even when subjected to temperature changes (hereinafter, also referred to as "connection reliability").

Therefore, an object of the present invention is to provide a method for manufacturing a substrate with conductive vias capable of exhibiting a sufficiently low connection resistance value even after wiring formation and allowing the obtained wiring board to have excellent connection reliability, and the substrate with conductive vias, as well as a method for manufacturing a wiring board with conductive vias having excellent connection reliability and the wiring board with conductive vias.

### Solution to Problem

One aspect of the present invention relates to the following method for manufacturing a substrate with conductive vias.
[1] A method for manufacturing a substrate with conductive vias, the method comprising: step S1 of preparing a substrate with a metal sintered body, the substrate comprising a substrate having holes opening on one or both main surfaces and a metal sintered body having a porous structure provided inside the holes, the metal sintered body being exposed at the openings of the holes; and step S2 of providing the metal sintered body with a resin-containing part containing a photosensitive resin composition or a cured product thereof.
[2] The method for manufacturing a substrate with conductive vias according to [1], wherein in step S2, the metal sintered body is provided with the resin-containing part and a resin-free part not containing a resin composition or a cured product thereof such that the resin-containing part is localized on the opening side.
[3] The method for manufacturing a substrate with conductive vias according to [1] or [2], wherein step S2 comprises: step S2-1a of impregnating at least a part of the metal sintered body with a negative-type photosensitive resin composition by laminating a film-shaped negative-type photosensitive resin composition onto a surface of the substrate with a metal sintered body; and step S2-2a of, after step S2-1a, removing the film-shaped negative-type photosensitive resin composition by a development treatment to expose the metal sintered body having the resin-containing part containing the negative-type photosensitive resin composition at the openings of the holes.
[4] The method for manufacturing a substrate with conductive vias according to [3], wherein step S2 further comprises step S2-3a of curing the negative-type photosensitive resin composition contained in the resin-containing part after step S2-2a.
[5] The method for manufacturing a substrate with conductive vias according to [4], wherein step S2 further comprises step S2-4a of performing a desmear treatment on at least the exposed surface of the metal sintered body after step S2-3a.
[6] The method for manufacturing a substrate with conductive vias according to [1] or [2], wherein step S2 comprises: step S2-1b of impregnating at least a part of the metal sintered body with a negative-type photosensitive resin composition by applying a liquid negative-type photosensitive resin composition onto a surface of the substrate with a metal sintered body; and step S2-2b of, after step S2-1b, removing the coating film of the liquid negative-type photosensitive resin composition by a development treatment to expose the metal sintered body having the resin-containing part containing the negative-type photosensitive resin composition at the openings of the holes.
[7] The method for manufacturing a substrate with conductive vias according to [6], wherein step S2 further comprises step S2-3b of curing the negative-type photosensitive resin composition contained in the resin-containing part after step S2-2b.
[8] The method for manufacturing a substrate with conductive vias according to [7], wherein step S2 further comprises step S2-4b of performing a desmear treatment on at least the exposed surface of the metal sintered body after step S2-3b.
[9] The method for manufacturing a substrate with conductive vias according to [1] or [2], wherein step S2 comprises: step S2-1c of impregnating at least a part of the metal sintered body with a positive-type photosensitive resin composition by applying a liquid positive-type photosensitive resin composition onto a surface of the substrate with a metal sintered body or by laminating a film-shaped positive-type photosensitive resin composition onto a surface of the substrate with a metal sintered body; and step S2-2c of, after step S2-1c, removing the coating film of the liquid positive-type photosensitive resin composition or the film-shaped positive-type photosensitive resin composition by exposure and a development treatment to expose the metal sintered body having the resin-containing part containing the positive-type photosensitive resin composition at the openings of the holes.
[10] The method for manufacturing a substrate with conductive vias according to [9], wherein the positive-type photosensitive resin composition contains a thermosetting component, and step S2 further comprises step S2-3c of thermally curing the positive-type photosensitive resin composition contained in the resin-containing part after step S2-2c.
[11] The method for manufacturing a substrate with conductive vias according to [10], wherein step S2 further comprises step S2-4c of performing a desmear treatment on at least the exposed surface of the metal sintered body after step S2-3c.

According to the method for manufacturing a substrate with conductive vias described in [1], it is possible to obtain a substrate with conductive vias that exhibits a sufficiently low connection resistance value even after wiring formation and allows the obtained wiring board to have excellent connection reliability. The present inventors infer that the reason such effects are achieved is as follows. First, since the conductive vias are formed by the metal sintered body having a porous structure, stress relaxation properties are obtained, and an effect of suppressing cracking of the material around the metal sintered body is easily obtained. On the other hand, the metal sintered body having a porous structure is susceptible to adverse effects of oxidation (for example, oxidation of the metal sintered body accompanying penetration of an aqueous solution) caused by penetration of chemicals and the like used during wiring formation. In contrast, in the method described in [1], it is considered that the adverse effects described above can be sufficiently mitigated by providing the resin-containing part in the metal sintered body. Note that the method described in Patent Literature 3 above can cause the copper sintered body having a porous structure to contain a cured product of a curable resin composition, but since the cured product of the resin tends to remain on the surface of the copper sintered body, the present inventors' studies have revealed that the conduction resistance increases after a reliability test under more severe conditions due to, for example, inhibition of deposition of an electrolytic copper plating film in the subsequent wiring formation step. In contrast, the method described in [1] is based on the finding that, when a photosensitive resin composition is used, the resin composition on the surface of the metal sintered body can be removed by the corresponding a development treatment while leaving the resin composition in the metal sintered body.

Another aspect of the present invention relates to the following method for manufacturing a wiring board with conductive vias.
A method for manufacturing a wiring board with conductive vias, the method comprising step S3 of forming a wiring electrically connected to the conductive vias on the substrate with conductive vias obtained by the method according to any one of [1] to [11].

Another aspect of the present invention relates to the following substrate with conductive vias or wiring board with conductive vias.
[13] A substrate with conductive vias, comprising a substrate having through-holes and conductive vias provided in the through-holes, wherein the conductive vias comprise a metal sintered body having a porous structure, and the metal sintered body comprises a resin-containing part containing a photosensitive resin composition or a cured product thereof.
[14] The substrate with conductive vias according to [13], wherein the metal sintered body further comprises a resin-free part not containing a resin composition or a cured product thereof, and the resin-containing part is localized on an opening side of the through-holes in the metal sintered body.
[15] A wiring board with conductive vias, comprising the substrate with conductive vias according to [13] or [14] and a wiring provided on the substrate with conductive vias and electrically connected to the conductive vias.

### Advantageous Effects of Invention

According to the present invention, it is possible to provide a method for manufacturing a substrate with conductive vias that is capable of exhibiting a sufficiently low connection resistance value even after wiring formation and enabling a resulting wiring board to have excellent connection reliability, and the substrate with conductive vias, as well as a method for manufacturing a wiring board with conductive vias having excellent connection reliability, and the wiring board with conductive vias.

The method for manufacturing a substrate with conductive vias and the substrate with conductive vias of the present invention are also useful as a technique for reducing the environmental burden due to plating.

### Brief Description of Drawings

FIG. 1 is a schematic view showing an example of a method for manufacturing a substrate with conductive vias according to the present embodiment.
FIG. 2 is a schematic view showing an example of a method for manufacturing a substrate with conductive vias according to the present embodiment.
FIG. 3 is a schematic view showing an example of a method for manufacturing a substrate with conductive vias according to the present embodiment.
FIG. 4 is a schematic view showing an example of a method for manufacturing a substrate with conductive vias according to the present embodiment.
FIG. 5 is a schematic view showing an example of a method for manufacturing a substrate with conductive vias according to the present embodiment.
FIG. 6 is a schematic view showing an example of a method for manufacturing a substrate with conductive vias according to the present embodiment.
FIG. 7 is a schematic view showing an example of a method for manufacturing a wiring board with conductive vias according to the present embodiment.
FIG. 8 is a schematic view showing a test piece.

### Description of Embodiments

Hereinafter, embodiments of the present invention will be described in detail with reference to the drawings. The present invention is not limited to the following embodiments. Note that, in the drawings, the same or corresponding parts are denoted by the same reference signs, and their repetitive description will be omitted.

### <Method for Manufacturing Substrate with Conductive Vias>

The method for manufacturing a substrate with conductive vias according to the present embodiment comprises: step S1 of preparing a substrate with a metal sintered body, the substrate comprising a substrate having holes opening on one or both main surfaces and a metal sintered body having a porous structure provided inside the holes, and the metal sintered body being exposed at the openings of the holes; and step S2 of providing the metal sintered body with a resin-containing part containing a photosensitive resin composition or a cured product thereof.

### [Step S1]

Step S1 may comprises: step a of preparing a substrate provided with holes and providing a metal paste part containing metal particles and a volatile solvent to cover at least the surface of the substrate around the holes while filling an inside of the holes; step b of heating the metal paste part and removing a part of the volatile solvent; step c of removing a portion of the metal paste part after heating to expose the surface, and forming a metal sintered body precursor having a planarized exposed surface and containing the metal particles and the remainder of the volatile solvent inside the holes; and step d of firing the metal sintered body precursor to form a metal sintered body having a porous structure.

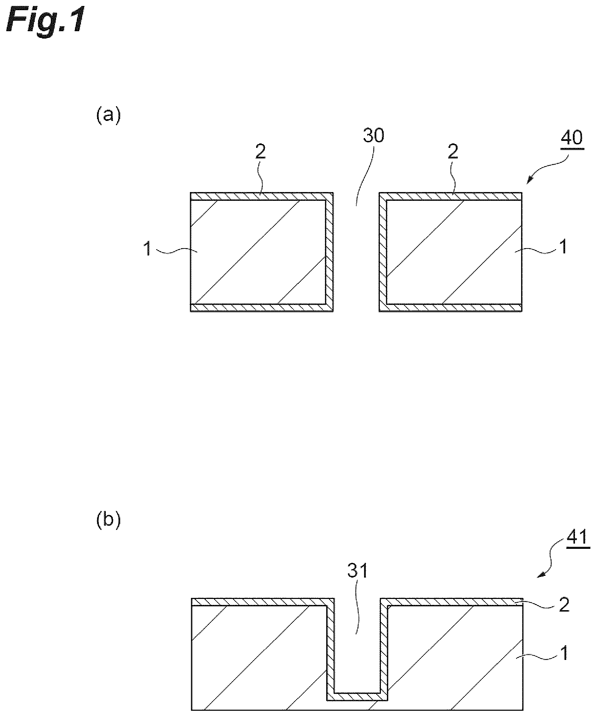

FIGS. 1 to 3 are schematic views showing examples of step S1. FIG. 1 illustrates an example of a substrate used in the method for manufacturing a substrate with conductive vias. Hereinafter, the method for manufacturing a substrate with conductive vias according to the present embodiment will be described with reference to these drawings. Note that, in the present embodiment, since the case where the metal paste contains the above-described copper particles as the metal particles is illustrated, copper particles, a copper layer, and a copper sintered body can be interpreted as metal particles, a metal layer, and a metal sintered body, respectively.

### [Step a]

Examples of the substrate provided with a hole prepared in this step include an organic substrate, a silicon substrate, a glass substrate, a ceramic substrate, a printed wiring board, a semiconductor package substrate, and the like. The silicon substrate may be a substrate formed of polycrystalline silicon or may be a square silicon substrate formed of polycrystalline silicon. The hole may be a through-hole or a blind-hole. In the present embodiment, for example, as illustrated in FIG. 1(a), it is possible to prepare a silicon substrate 40 including a silicon wafer 1 provided with a through-hole 30 and a metal coating 2 provided on the wall surface of the through-hole and the surfaces of the silicon wafer 1. The through-hole 30 penetrates through both main surfaces of the silicon substrate 40. Although a case where a conductive via is provided in the silicon substrate 40 will be described as an example, the silicon wafer may be replaced with another insulating base in the following description.

The thickness of the silicon wafer 1 may be 100 µm or more, 200 µm or more, or 300 µm or more from the viewpoint of suppressing warpage of the substrate after sintering, or may be 800 µm or less, 300 µm or less, 200 µm or less, or 100 µm or less from the viewpoint of reducing the weight and increasing the density of the substrate. In addition, when a polycrystalline silicon substrate or the like is used, the thickness may be 0.05 to 2 mm, 0.1 mm to 1.5 mm, or 0.2 to 1 mm.

The upper limit value of the hole diameter of the through-hole 30 may be 200 µm or less, 100 µm or less, or 60 µm or less from the viewpoint of achieving high integration of a semiconductor device to be obtained, and the lower limit value of the hole diameter of the through-hole 30 is not particularly limited, but may be 10 µm or more, 20 µm or more, 30 µm or more, or 50 µm or more.

The ratio of the depth to the hole diameter of the through-hole 30 [(depth)/(hole diameter)] may be 0.5 to 40, 1 to 20, or 2 to 10.

The number of through-holes 30 provided in the silicon substrate 40 may be 100 or more, 200 or more, or 300 or more per 1 cm² of the main surface of the substrate from the viewpoint of achieving high integration of a semiconductor device to be obtained.

The metal coating 2 may be provided on both main surfaces of the silicon wafer 1 and the wall surface of the through-hole 30, may be provided on at least one main surface of the silicon wafer 1 and the wall surface of the through-hole 30, may be provided only on the wall surface of the through-hole 30, or may not be provided. In the embodiment illustrated in FIG. 1(a), the silicon substrate 40 is provided with the metal coating 2 on both main surfaces of the silicon wafer 1 and the wall surface of the through-hole 30.

Examples of the metal coating 2 include titanium, nickel, chromium, copper, aluminum, palladium, platinum, gold, and the like. From the viewpoint of adhesion, the metal coating 2 is preferably a coating with titanium, nickel, and copper layered in this order. The surface of the silicon wafer 1 is oxidized to form silicon oxide, and a titanium layer is formed on the silicon oxide, thereby improving adhesiveness. In addition, by providing a nickel layer on the titanium layer and providing a copper layer thereon, the diffusion of copper into the silicon wafer 1 can be suppressed as compared with a case where the copper layer is directly provided on the titanium layer. Furthermore, by providing a copper layer on the surface, the adhesion between the copper layer and the copper particles in the metal paste is improved, and the reliability is improved.

Note that, as illustrated in FIG. 1(b), in a case of preparing a silicon substrate 41 provided with a blind- hole 31 as a hole, a conductive via serving as a through-electrode can be formed by grinding the side of the silicon substrate opposite to the surface on which the blind- hole 31 opens, after step a, step b, step c, or step d. Examples of the grinding method include mechanical polishing, chemical mechanical polishing, and the like.

The metal paste part 3 can be provided, for example, by a method of directly applying a metal paste containing metal particles and a volatile solvent onto the silicon substrate 40, or a method of producing a film precoated with the metal paste and pressing the film against the substrate.

Examples of the method for applying or filling the metal paste include printing methods such as a screen printing method, an inkjet printing method, an intaglio printing method, a planographic printing method, an offset printing method, and a flexographic printing method, and printing methods combining these printing methods, and methods such as a spin coating method, a dip method, a roll method, a squeegee method, and a press method. Among these methods, a screen-printing method or a squeegee method of directly filling the substrate under a vacuum atmosphere, and a vacuum press method of pressing a film precoated with the metal paste under a vacuum atmosphere are preferred.

The content of the metal particles in the metal paste of the present embodiment may be 95.0 mass% or more, 95.2 mass% or more, 95.5 mass% or more, 95.7 mass% or more, or 96 mass% or more, and may be 98 mass% or less, 97 mass% or less, or 96.5 mass% or less, and may be 95.0 to 98 mass%, 95.2 to 97 mass%, or 95.7 to 96.5 mass%, based on the total amount of the metal paste.

Examples of the metal particles include particles of nickel, silver, copper, gold, palladium, platinum, solder, and the like. The metal particles may contain a plurality of metals such as silver-coated copper particles. When the metal paste contains copper particles, it is easy to obtain a conductor having sufficient conductivity and a resistance value that is unlikely to increase even when subjected to a temperature change, and a base having a through-electrode with sufficient conductivity and excellent connection reliability.

In the present embodiment, the metal particles may include first metal particles having a volume average particle diameter of 0.8 µm or more and second metal particles having a volume average particle diameter of 0.5 µm or less.

Note that, in the present specification, the volume average particle diameter of particles (hereinafter, also referred to as "average particle diameter" in some cases) means a 50% volume average particle diameter (D50). When the volume average particle diameter of the metal particles is determined, the volume average particle diameter can be determined by a method of dispersing metal particles serving as a raw material in a dispersion medium such as water or alcohol and measuring the resulting dispersion with a laser diffraction/scattering particle size distribution analyzer, or other methods.

The first metal particles and the second metal particles may be copper particles from the viewpoint of reducing resistance, ensuring resistance to ion migration, and ease of wiring formation. The present embodiment will be described in detail by taking as an example of a case where the first metal particles are copper particles (hereinafter referred to as "first copper particles") and the second metal particles are copper particles (hereinafter referred to as "second copper particles").

### (First Copper Particles)

The average particle diameter of the first copper particles may be 0.8 µm or more, 1.0 µm or more, 2.0 µm or more, or 3.0 µm or more from the viewpoint of improving the sintering density in the holes (for example, through-holes or blind- holes) of the substrate and suppressing the occurrence of voids and cracks in the holes, and may be 10 µm or less, 8.0 µm or less, 5.0 µm or less, or 4.0 µm or less from the viewpoint of suppressing clogging of the particles in fine vias having an inner diameter of 100 µm or less and improving the fillability, and may be 0.8 µm to 4.0 µm, 1.0 µm to 3.5 µm, or 1.2 µm to 3.0 µm from the viewpoint of suppressing the occurrence of voids and cracks and suppressing clogging of the particles in fine vias. The ratio (DC1/DH) of the average particle diameter DC1 of the first copper particles to the inner diameter DH of the hole may be 0.01 or more, 0.03 or more, or 0.04 or more from the viewpoint of suppressing clogging of the particles in the fine vias and improving the fillability, and may be 0.15 or less, 0.1 or less, or 0.05 or less from the viewpoint of suppressing the occurrence of voids and cracks by reducing shrinkage caused by firing. In addition, from the above-described viewpoints, the ratio (DC1/DH) may be 0.01 to 0.15 or 0.03 to 0.1.

The shape of the first copper particles may be, for example, a spherical shape, a lump shape, a needle shape, a flat shape (flake shape), an approximately spherical shape, or the like. The first metal particles may be an aggregate of copper particles having these shapes. The metal paste of the present embodiment can contain spherical copper particles as the first copper particles from the viewpoint of reducing a step height step between the conductive via part to be formed and the substrate surface and suppressing the fluctuation in connection resistance even after a reliability test (for example, a temperature cycle test).

In the first copper particles, a content ratio of particles having an aspect ratio of 2 or less, such as spherical particles, may be 40 mass% or more, 50 mass% or more, 60 mass% or more, 80 mass% or more, or 100 mass%, and may be 40 to 90 mass%, 50 to 80 mass%, or 60 to 70 mass%, from the viewpoint of improving the printability of the metal paste. Note that the aspect ratio (major axis/minor axis) of a particle can be determined, for example, by observing an SEM image of the particle and measuring the major axis and the minor axis (for example, thickness).

In addition, the metal paste of the present embodiment may contain flake-shaped copper particles as the first copper particles from the viewpoint of suppressing the occurrence of voids and cracks by reducing shrinkage due to firing, and may contain spherical copper particles and flake-shaped copper particles from the viewpoint of suppressing the occurrence of voids and cracks by lowering the viscosity of the metal paste to improve the filling property into fine vias and reducing shrinkage due to firing. When spherical copper particles and flake-shaped copper particles are used in combination, the mass ratio thereof (spherical copper particles)/(flake-shaped copper particles) may be 1 to 9, 1.2 to 2.5, or 1.4 to 4.

The flake-shaped copper particles may have an aspect ratio of 1.5 or more, 2 or more, or 3 or more.

When spherical copper particles having an aspect ratio of 2 or less and flake-shaped copper particles having an aspect ratio of more than 2 are used in combination, a mass ratio thereof (spherical copper particles)/(flake-shaped copper particles) may be 0.6 to 9, 1.0 to 4.0, or 1.5 to 2.4.

The first copper particles may be prepared by a chemical reduction method, an atomization method, an electrolytic method, a pulverization method, a plasma rotary electrode method, a homogeneous liquid spraying method, a heat treatment method, or the like, or may be a wet copper powder or an atomized copper powder from the viewpoint of easily obtaining a uniform diameter and improving the dispersibility of the metal paste.

The first copper particles may contain a wet copper powder. In this case, a conductive via having excellent conductivity is easily obtained. It is considered that such an effect is obtained based on the properties of the wet copper powder being easily bonded to the copper particles blended as the second metal. The wet copper powder may have a D90/D50 of 1.5 or less.

In addition, the copper particles can contain a wet copper powder and an atomized copper powder. In this case, it is easy to improve the printability of the metal paste, reduce the step height between the conductive via part to be formed and the substrate surface, and suppress fluctuation in connection resistance even after a reliability test (for example, a temperature cycle test). The reason such an effect can be obtained is inferred as follows. Specifically, it is considered that since the wet copper powder that is easily bonded to the second copper particles and that has a uniform particle diameter and the atomized copper powder that has a wide particle size distribution coexist, the wet copper powder bonds to the second copper particles while bonding the particles of the atomized copper powder together, and as a result, it is possible to achieve the formation of a strong sintered body based on the close-packed structure, and the suppression of shrinkage during sintering to suppress the occurrence of voids and cracks and suppress recesses. The atomized copper powder may have a D90/D50 of 1.6 or more, 1.7 or more, or 1.8 or more.

When the first copper particles contain the wet copper powder and the atomized copper powder, the content ratio of the wet copper powder may be more than 0 parts by mass and less than 100 parts by mass, or may be 20 to 80 parts by mass, with respect to a total of 100 parts by mass of the wet copper powder and the atomized copper powder.

As the first copper particles, commercially available copper particles can be used. Examples of the commercially available first copper particles include 1050Y (trade name, manufactured by MITSUI MINING & SMELTING CO., LTD., average particle diameter (D50): 0.81 µm, D90: 1.1 µm, spherical shape, wet copper powder), 1100Y (trade name, manufactured by MITSUI MINING & SMELTING CO., LTD., average particle diameter (D50): 1.1 µm, D90: 1.6 µm, spherical shape, wet copper powder), 1200Y (trade name, manufactured by MITSUI MINING & SMELTING CO., LTD., average particle diameter (D50): 2.1 µm, D90: 3.1 µm, spherical shape, wet copper powder), 1300Y (trade name, manufactured by MITSUI MINING & SMELTING CO., LTD., average particle diameter (D50): 3.5 µm, D90: 5 µm, spherical shape, wet copper powder), 1100YP (trade name, manufactured by MITSUI MINING & SMELTING CO., LTD., average particle diameter (D50): 1.4 µm, D90: 2.3 µm, flat shape, wet copper powder), 1200YP (trade name, manufactured by MITSUI MINING & SMELTING CO., LTD., average particle diameter (D50): 3.1 µm, D90: 5.3 µm, flat shape, wet copper powder), MA-C02K (trade name, manufactured by MITSUI MINING & SMELTING CO., LTD., average particle diameter (D50): 1.8 µm, D90: 3.6 µm, spherical shape, atomized copper powder), MA-C025K (trade name, manufactured by MITSUI MINING & SMELTING CO., LTD., average particle diameter (D50): 2.4 µm, D90: 5.2 µm, spherical shape, atomized copper powder), and MA-C03K (trade name, manufactured by MITSUI MINING & SMELTING CO., LTD., average particle diameter (D50): 3.4 µm, D90: 6.3 µm, spherical shape, atomized copper powder).

The first copper particles may be treated with a surface treatment agent from the viewpoint of dispersion stability and oxidation resistance. The surface treatment agent may be removed during wiring formation (during sintering of copper particles). Examples of such a surface treatment agent include: aliphatic carboxylic acids such as palmitic acid, stearic acid, arachidic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohols such as p-phenylphenol; alkylamines such as octylamine, dodecylamine, and stearylamine; aliphatic nitriles such as stearonitrile and decanenitrile; silane coupling agents such as alkylalkoxysilane; and polymer treatment agents such as polyethylene glycol, polyvinyl alcohol, polyvinyl pyrrolidone, and silicone oligomers. The surface treatment agents may be used alone or may be used in combination of two or more kinds.

The treatment amount of the surface treatment agent may be an amount of one or more molecular layers on a particle surface. The treatment amount of such a surface treatment agent varies depending on the specific surface area of the first copper particles, the molecular weight of the surface treatment agent, and the minimum coating area of the surface treatment agent. The treatment amount of the surface treatment agent is usually 0.001 mass% or more.

The treatment amount of the surface treatment agent can be calculated from the number (n) of molecular layers attached to the surface of the first copper particles, the specific surface area (Aₚ) (unit: m²/g) of the first copper particles, the molecular weight (Mₛ) (unit: g/mol) of the surface treatment agent, the minimum coating area (S_{S}) (unit: m²/unit) of the surface treatment agent, and Avogadro's number (N_{A}) (6.02 × 10²³). Specifically, the treatment amount of the surface treatment agent is calculated according to the equation of treatment amount (mass%) of surface treatment agent = {(n × Aₚ × Mₛ)/(S_{S} × N_{A} + n × Aₚ × Mₛ)} × 100%.

The specific surface area of the first copper particles can be calculated by measuring the dried copper particles in accordance with the BET specific surface area measurement method. When the surface treatment agent is a linear saturated fatty acid, the minimum coating area of the surface treatment agent is 2.05 × 10⁻¹⁹ m²/one molecule. For other surface treatment agents, for example, it can be measured by calculation from a molecular model or the method described in "Chemistry and Education" (Katsuhiro Ueda, Sumio Inafuku, and Iwao Mori, 40 (2), 1992, pp. 114-117). An example of a quantitative method of the surface treatment agent will be described. The surface treatment agent can be identified with a thermal desorption gas chromatograph mass spectrometer using a dry powder obtained by removing the dispersion medium from the metal paste, thereby enabling the number of carbon atoms and the molecular weight of the surface treatment agent to be determined. The carbon content ratio in the surface treatment agent can be analyzed by carbon content analysis. Examples of the carbon content analysis method include a high-frequency induction heating furnace combustion-infrared absorption method. The amount of the surface treatment agent can be calculated from the number of carbon atoms, the molecular weight, and the carbon content ratio of the identified surface treatment agent by the above-described equation.

### (Second Copper Particles)

The average particle diameter of the second copper particles may be 0.5 µm or less, 0.4 µm or less, 0.3 µm or less, or 0.2 µm or less from the viewpoint of sinterability, may be 0.01 µm or more, 0.03 µm or more, 0.05 µm or more, 0.08 µm or more, or 0.1 µm or more from the viewpoint of reducing synthesis cost, good dispersibility, and reducing the use amount of a surface treatment agent, or may be 0.1 µm to 0.3 µm, 0.12 µm to 0.28 µm, or 0.15 µm to 0.25 µm from the viewpoint of obtaining sinterability at a low temperature and good dispersibility in the paste.

The second copper particles function as copper particles that suitably bond the first copper particles. In addition, the second copper particles are more excellent in sinterability than the first copper particles and can have a function of promoting sintering of the copper particles. For example, the copper particles can be sintered at a lower temperature as compared with a case where the first copper particles are used alone as the copper particles.

The second copper particles may be a wet copper powder prepared by a chemical reduction method.

The shape of the second copper particles may be, for example, a spherical shape, an agglomerated shape, a needle shape, a flat shape (flake shape), an approximately spherical shape, or the like. The second copper particles may be an aggregate of copper particles having these shapes. From the viewpoint of dispersibility and fillability, the shape of the second copper particles may be a spherical shape, an approximately spherical shape, or a flat shape (flake shape), and from the viewpoint of flammability and mixability with the first copper particles and the like, the shape may be a spherical shape or an approximately spherical shape.

The aspect ratio of the second copper particles may be 5 or less, 4 or less, or 3 or less from the viewpoint of dispersibility, fillability, and mixing property with the first copper particles.

As the second copper particles, either synthetic or commercially available products can be used. Examples of the commercially available second copper particles include CH0200L1 (trade name, manufactured by MITSUI MINING & SMELTING CO., LTD., average particle diameter (D50): 200 nm, spherical shape) and Tn-Cu100 (manufactured by TAIYO NIPPON SANSO CORPORATION, average particle diameter (D50): 120 nm, spherical shape).

The second copper particles may be treated with a specific surface treatment agent. Examples of the specific surface treatment agent include an organic acid having 8 to 16 carbon atoms. Examples of the organic acid having 8 to 16 carbon atoms include: saturated fatty acids such as caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyl tridecanoic acid, ethyl dodecanoic acid, propyl undecanoic acid, butyl decanoic acid, pentyl nonanoic acid, hexyl octanoic acid, pentadecanoic acid, methyl tetradecanoic acid, ethyl tridecanoic acid, propyl dodecanoic acid, butyl undecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, and sapienic acid; and aromatic carboxylic acids such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. The organic acids may be used alone or may be used in combination of two or more kinds. By combining such an organic acid with the second copper particles described above, the dispersibility of the second copper particles and the releasability of the organic acid during sintering tend to be both achieved.

The treatment amount of the surface treatment agent may be an amount in which one-molecular layer to three-molecular layer is attached to the surface of a second copper particle. The treatment amount of the surface treatment agent may be 0.07% by mass or more, 0.10% by mass or more, or 0.2% by mass or more, or may be 2.1% by mass or less, 1.6% by mass or less, or 1.1% by mass or less. The surface treatment amount of the second copper particles can be calculated by the method described above for the first copper particles. The same applies to the specific surface area, the molecular weight of the surface treatment agent, and the minimum coating area of the surface treatment agent.

The content of the second metal particles in the metal paste is 50 mass% or less based on the total amount of the metal particles from the viewpoint of connection reliability, and may be 10 to 50 mass% or 20 to 40 mass% from the viewpoint of lowering the sintering temperature to improve adhesion to the underlying metal layer, reducing the porosity of the sintered body, suppressing shrinkage during sintering, and suppressing the occurrence of cracks.

The total content of the first copper particles and the second copper particles in the metal paste may be 100 parts by mass, 85 to 99.5 parts by mass, 90 to 99 parts by mass, or 95 to 98 parts by mass, when the total amount of the metal particles is 100 parts by mass.

The contents of the first copper particles and the second copper particles may be 50 to 90 parts by mass and 50 to 10 parts by mass, 55 to 85 parts by mass and 45 to 15 parts by mass, or 60 to 80 parts by mass and 40 to 20 parts by mass, respectively, with respect to 100 parts by mass of the total of the first copper particles and the second copper particles.

The metal paste of the present embodiment may contain copper particles and metal particles other than the copper particles (hereinafter, also referred to as "other metal particles"). In this case, the other metal particles may be nickel particles, silver particles, gold particles, palladium particles, platinum particles, or solder particles. These can be contained singly or in combination of two or more kinds thereof. The average particle diameter of the other metal particles may be 0.01 µm or more, 0.03 µm or more, or 0.05 µm or more, or may be 5 µm or less, 3.0 µm or less, or 2.0 µm or less. The average particle diameter of the solder particles may be 1.0 µm or more, 1.5 µm or more, 2.0 µm or more, 3.0 µm or more, or 4.0 µm or more, or may be 15 µm or less, 10 µm or less, 8.0 µm or less, or 5.0 µm or less.

The content of the other metal particles may be 5 parts by mass or less, 3 parts by mass or less, 1 part by mass or less, or 0.8 parts by mass or less, when the total amount of the copper particles is 100 parts by mass. The metal paste of the present embodiment may be free of solder particles as the other metal particles.

### [Volatile Solvent]

Examples of the volatile solvent include: monohydric and polyhydric alcohols such as pentanol, hexanol, heptanol, octanol, decanol, ethylene glycol, diethylene glycol, propylene glycol, butylene glycol (1,3-butanediol or the like), α-terpineol, and isobornyl cyclohexanol (MTPH); ethers such as ethylene glycol butyl ether, ethylene glycol phenyl ether, diethylene glycol methyl ether, diethylene glycol ethyl ether (ethyl carbitol), diethylene glycol butyl ether (diethylene glycol mono-n-butyl ether or the like), diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as dimethyl phthalate, ethylene glycol ethyl ether acetate, ethylene glycol butyl ether acetate, propylene glycol diacetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; aromatic hydrocarbons such as benzene, toluene, and xylene; mercaptans having an alkyl group having 1 to 18 carbon atoms; and mercaptans having a cycloalkyl group having 5 to 7 carbon atoms. Examples of the mercaptans having an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans having a cycloalkyl group having 5 to 7 carbon atoms include cyclopentyl mercaptan, cyclohexyl mercaptan, and cycloheptyl mercaptan. The volatile solvents may be used alone or may be used in combination of two or more kinds.

The metal paste of the present embodiment may contain a solvent having a vapor pressure of 4 Pa or more and 30 Pa or less at 20°C (hereinafter, also referred to as a "high vapor pressure solvent") as a volatile solvent from the viewpoint of printability and suppressing volume shrinkage before and after firing the conductive via precursor (for example, between step C of forming the conductive via precursor and step d of firing the conductive via precursor) to suppress voids and cracks. The high vapor pressure solvent may be used alone or may be used in combination of two or more kinds.

Examples of the high vapor pressure solvent include α-terpineol, 1,3-butanediol, ethyl carbitol, propylene glycol diacetate, and the like.

The metal paste of the present embodiment may contain a solvent having a vapor pressure of less than 4 Pa at 20°C (hereinafter, also referred to as a "low vapor pressure solvent") as a volatile solvent from the viewpoint of suppressing powderization by drying associated with solvent evaporation during printing or preparation of the paste. The low vapor pressure solvent may be used alone or may be used in combination of two or more kinds thereof.

Examples of the low vapor pressure solvent include isobornyl cyclohexanol (MTPH), dimethyl phthalate, diethylene glycol mono-n-butyl ether, and the like.

The metal paste of the present embodiment may contain the high vapor pressure solvent and the low vapor pressure solvent from the viewpoint of achieving both printability and the suppression of volume shrinkage before and after firing the conductive via precursor (for example, between step C of forming the conductive via precursor and step d of firing the conductive via precursor) to suppress voids and cracks. In this case, each of the high vapor pressure solvent and the low vapor pressure solvent may be used alone or both may be used in combination of two or more kinds thereof. The content ratio of the high vapor pressure solvent to the low vapor pressure solvent may be 20/80 to 80/20 or 30/70 to 70/30 in a mass ratio of [high vapor pressure solvent/low vapor pressure solvent].

### solvent].

The content of the volatile solvent in the metal paste of the present embodiment may be 2 mass% or more, 3 mass% or more, or 3.5 mass% or more, and may be 5 mass% or less, 4.8 mass% or less, 4.5 mass% or less, 4.3 mass% or less, or 4 mass% or less, and may be 2 to 5 mass%, 3 to 4.8 mass%, or 3.5 to 4.5 mass%, based on the total amount of the metal paste.

The metal paste of the present embodiment may contain a resin component such as an epoxy resin. The metal paste of the present embodiment may have a content of the resin component of 10 mass% or less or 5 mass% or less, or may be free of a resin component.

The metal paste can be prepared by mixing the metal particles such as the copper particles described above and arbitrary components (such as additives) with the volatile solvent described above. After mixing the respective components, a stirring treatment may be performed. The maximum diameter of a dispersion may be adjusted by a classification operation. In addition, means such as a three-roll mill, a kneader, and a planetary mixer can be used for mixing the respective components.

When the metal paste contains the first copper particles and the second particles described above, the second copper particles, the surface treatment agent, and the dispersion medium may be mixed in advance and subjected to a dispersion treatment to prepare a dispersion of the second copper particles, and the first copper particles, and as necessary, other metal particles and arbitrary additives may be further mixed to complete the preparation of the metal paste. By adopting such a procedure, the dispersibility of the second copper particles is improved, the mixability with the first copper particles is improved, and the performance of the metal paste is further improved. Aggregates may be removed by subjecting the dispersion of the second copper particles to a classification operation.

The metal paste of the present embodiment may have a viscosity at 25°C of 100 to 600 Pa·s or 150 to 400 Pa·s from the viewpoint of printability. The viscosity of the metal paste is measured using a micro spiral viscometer PCU-02V (trade name, manufactured by Malcom Co., Ltd.) under conditions of a rotation speed of 10 rpm and a temperature of 25°C.

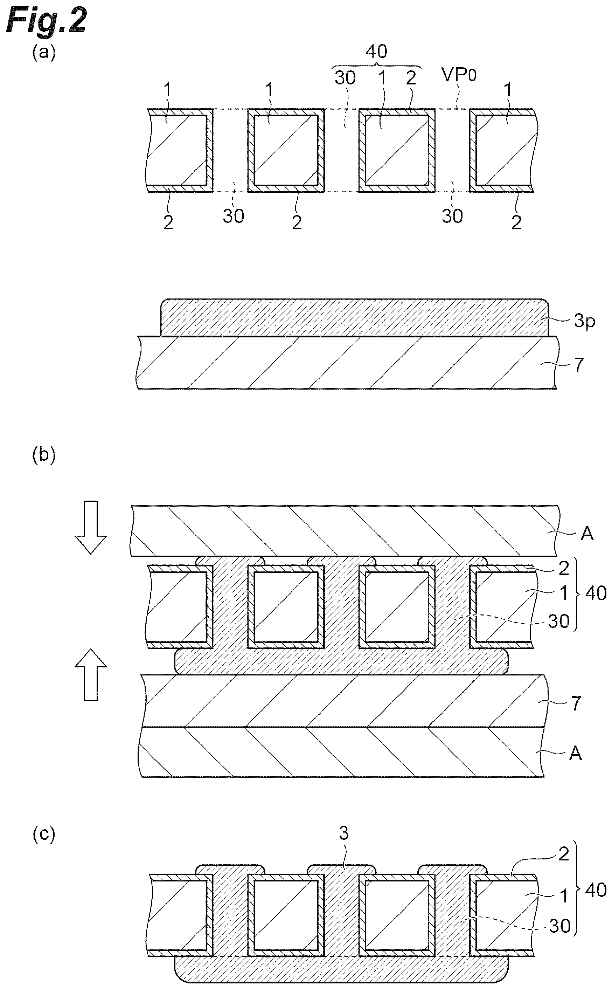

When a film onto which the metal paste has been applied in advance is used, as illustrated in FIGS. 2(a) to 2(c), the metal paste part 3 can be provided, for example, by preparing a metal particle film in which a metal particle-containing layer 3p formed of a metal paste containing metal particles and a volatile solvent is provided on a support film 7, and pressing the metal particle film against the substrate.

Examples of the support film 7 include a polyimide film, a polyethylene naphthalate film, and a polyethylene terephthalate film. The thickness of the support film may be 20 to 200 µm, 25 to 175 µm, or 30 to 150 µm from the viewpoint of workability for forming the metal particle-containing layer by coating.

The composition of the metal particles and the volatile solvent in the metal particle-containing layer can be appropriately set so that the conditions in the metal paste of the present embodiment described above are satisfied. The thickness of the metal particle-containing layer may be set so that the through-holes or the blind- holes can be sufficiently filled with the metal paste, and may be 100 µm or less. From the viewpoint of easily ensuring sufficient fillability into the through-holes or the blind-holes, the thickness of the metal particle-containing layer may be 30 µm or more, 40 µm or more, or 50 µm or more.

From the viewpoint of suppressing the occurrence of voids in the through-holes or the blind-holes, the metal particle-containing layer may have an undulation (height difference) of 20 µm or less or 10 µm or less on the surface opposite to the support film. By reducing the undulation (height difference), it becomes easy to fill a large number of through-holes or blind-holes present in the base simultaneously when the metal particle film is pressed to fill the holes of the base with the metal particle composition, and it becomes easier to reduce completely unfilled through-holes or blind-holes as well as through-holes or blind-holes in which voids partially occur. The evaluation of the undulation (height difference) can be measured by a non-contact method using a laser displacement meter or the like.

The above-described metal particle film can be produced by applying the metal paste of the present embodiment described above on a support film to form a metal particle-containing layer having a concentration of metal particles of 95.0% by mass or more, or by applying a metal paste having an increased content of a volatile solvent (for example, increased to an amount such that the concentration of the metal particles is less than 94.0% by mass) and drying the coating film to form a metal particle-containing layer having a concentration of metal particles of 95.0% by mass or more.

Examples of the method for applying the metal paste include application methods using screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, and the like.

From the viewpoint of coating workability and uniformity of the coating film thickness, the metal paste can be applied onto the support film by screen printing.

The thickness of the coating film may be 1 µm or more, 2 µm or more, 3 µm or more, 5 µm or more, 10 µm or more, 15 µm or more, or 20 µm or more, and may be 300 µm or less, 250 µm or less, 200 µm or less, 150 µm or less, 120 µm or less, 100 µm or less, 80 µm or less, or 50 µm or less.

The step of drying the coating film to form the metal particle-containing layer can be performed at normal temperature or a temperature of normal temperature to 100°C or lower, and the atmosphere may be in the ambient atmosphere or in nitrogen.

In step a, the above-described metal particle film is pressed against the silicon substrate 40 so that the metal particle-containing layer 3p of the metal particle film is brought into contact with the silicon substrate 40 to fill the through-hole 30 of the silicon substrate 40 with the metal paste. In this case, for example, as illustrated in FIG. 2(b), the metal particle film and the silicon substrate 40 can be sandwiched and pressurized by a pressure jig A from above and below. The pressure jig A is not particularly limited and may be a commercially available one, and may also be manufactured using a metal member having a flat part. For example, a pressure jig including two or more of the above-described metal members can press the metal particle film against the silicon substrate by sandwiching the metal particle film and the silicon substrate between the metal members arranged so that the flat portions face each other. The pressure jig A may have a mechanism that adjusts the pressure applied to the metal particle film and the silicon substrate. As the pressure adjusting means, a spring or the like can be used. In the present embodiment, a vacuum press method of performing pressing under a vacuum atmosphere may also be used.

The pressing can be performed, for example, under conditions of a temperature of normal temperature to 50°C or lower, and the atmosphere may be in vacuum, in the ambient atmosphere, or in nitrogen. For the purpose of reducing voids, the metal particle film may be pressed against the silicon substrate after being held at a degree of vacuum of 1,000 Pa or less or a degree of vacuum of 200 Pa or less. The pressure of the pressure jig when pressing the metal particle film against the silicon substrate may be a pressure in a range in which the silicon wafer is not cracked, and may be, for example, 0.01 MPa or more, 0.1 MPa or more, or 1 MPa or more.

The metal paste part 3 may cover at least the surface surrounding the hole of the substrate while filling the inside of the hole, and as illustrated in FIGS. 2(b) and 2(c), the metal paste part may protrude from an opening (VP₀ in FIG. 2(a)) of the through-hole located on the side opposite to the side of the substrate against which the metal particle film is pressed to cover the surface around the holes.

### [Step b]

In this step, the metal paste part is heated to remove a part of the volatile solvent, and in other words, the metal paste part is heated so that a part of the volatile solvent remains. Note that, when the metal particle film described above is used, the metal paste part can be heated after the support film is peeled off.

The heating can be carried out, for example, by using a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, a steam heating furnace, a hot plate press device, or the like.

The heating atmosphere may be the air, may be an oxygen-free atmosphere such as nitrogen and a rare gas, or may be a reducing atmosphere such as hydrogen and formic acid. In the case of the air, when the heating temperature exceeds 100°C, the copper particles are easily oxidized, but when the metal paste part contains the high vapor pressure solvent described above as a volatile solvent, a part of the volatile solvent can be removed at a temperature of less than 100°C, 95°C or lower, or 90°C or lower. Note that, in a case where the metal paste part does not contain a high vapor pressure solvent as a volatile solvent, for example, contains only the low vapor pressure solvent described above, when heating is performed at 110°C or higher, 130°C or higher, or 150°C or higher in an oxygen-free atmosphere or a reducing atmosphere, the oxidation of the copper particles can be suppressed while removing a part of the volatile solvent.

When the metal paste part contains a high vapor pressure solvent, the heating temperature may be 70°C or higher and lower than 100°C, or 80°C or higher and 95°C or lower from the viewpoint of suppressing the oxidation of the copper particles, and the heating time may be 5 to 60 minutes or 10 to 30 minutes from the viewpoint of suppressing the oxidation of the copper particles.

In addition, from the viewpoint of suppressing the occurrence of voids or cracks by suppressing volume shrinkage before and after firing the metal sintered body precursor (for example, between the step c of forming the metal sintered body precursor and the step d of firing the metal sintered body precursor), heating may be performed so that the concentration of the metal particles in the metal paste part is 96 mass% or more, 97.5 mass% or more, or 98 mass% or more.

### [Step c]

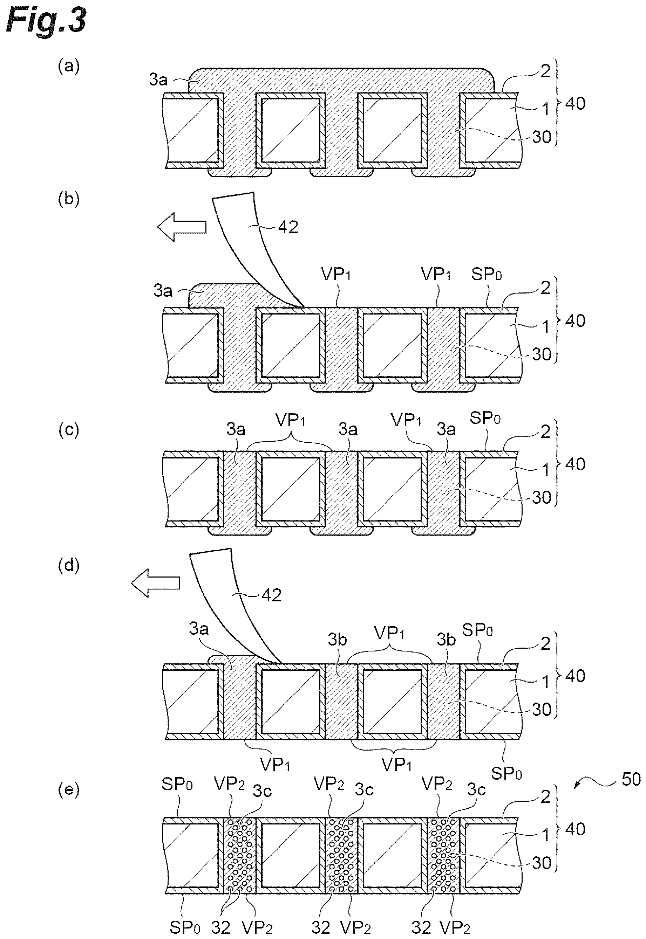

In this step, as illustrated in FIGS. 3(a) to 3(d), the metal paste filling the holes is planarized (or smoothed) while removing the metal paste covering the surface of the substrate from the heated metal paste part 3a obtained in step b. Thereby, a metal sintered body precursor 3b having a planarized exposed surface VP₁ and containing the metal particles and the remainder of the volatile solvent can be formed inside the hole (through-hole 30) (FIG. 3(d)).

The metal paste part can be removed, for example, by using a rubber squeegee 42 as illustrated in FIGS. 3(b) and 3(d). As a result, a portion of the metal paste part (the metal paste covering the surface of the substrate and the metal paste protruding from the hole) can be removed so that the surface SP₀ of the substrate 40 and the exposed surface VP₁ of the conductive via precursor 3b are flush with each other. In addition, as another method, removal with a metal squeegee such as SUS can be mentioned.

The step height between the surface SP₀ of the substrate 40 and the exposed surface VP₁ of the conductive via precursor 3b may be 5 µm or less or 3 µm or less in a direction perpendicular to the substrate surface. In addition, the average step height calculated by the following method may fall within the above-described range.

### (Average Step Height)

The average step height is calculated by acquiring an image of a cross-section passing through the center of a hole (via), binarizing the cross-section image to obtain a cross-sectional area Sa surrounded by inner walls of the hole (via), an exposed surface of a conductive via precursor, and an opening surface of the hole (via), and dividing the cross-sectional area Sa by an interval Wa between the inner walls of the hole.

### [Step d]

In this step, the metal sintered body precursor 3b formed in step c is fired. Thereby, a metal sintered body having a porous structure can be formed. The porosity of the metal sintered body may be 10% or less, 1.0 to 6.5%, or 1.5 to 5.0% from the viewpoint of suppressing penetration of chemicals such as a resist stripping solution and a preplating treatment solution into the metal sintered body when immersed in the chemicals in a subsequent step, thereby improving reliability. When the metal sintered body is formed of a copper sintered body, the porosity of the copper sintered body may fall within the above range. The porosity can be determined by the method described in the Examples.

The firing can be performed by heat treatment. The heat treatment can be carried out, for example, by using heating means such as a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, and a steam heating furnace.

The atmosphere during the firing may be an oxygen-free atmosphere from the viewpoint of suppressing oxidation of the copper sintered body or may be a reducing atmosphere from the viewpoint of removing the surface oxide of the copper particles in the conductive via precursor. Examples of the oxygen-free atmosphere include an atmosphere into which an oxygen-free gas such as nitrogen or a rare gas is introduced, or a vacuum atmosphere. Examples of the reducing atmosphere include a pure hydrogen gas, a mixed gas of hydrogen and nitrogen represented by a forming gas, nitrogen containing a formic acid gas, a mixed gas of hydrogen and a rare gas, and a rare gas containing a formic acid gas. When the conductive via precursor is sintered by heating without pressurization, the atmosphere may be a pure hydrogen gas or a mixed gas of hydrogen and nitrogen represented by a forming gas, and is preferably a pure hydrogen gas. The heating in the pure hydrogen gas can lead to a decrease in the sintering temperature of the copper particles. When the pure hydrogen gas is used, the gas reaches the center part of the through-hole 30 even though the thickness of the substrate is as large as 600 µm and the diameter of the through-hole 30 is as small as 10 µm, and thus it is easy to obtain a metal body containing a copper sintered body.

The maximum temperature reached during the heat treatment may be 150°C or higher, and may be 350°C or lower, 300°C or lower, or 260°C or lower, from the viewpoint of reducing heat damage to each member and improving the yield. When the maximum temperature reached is 150°C or higher, sintering tends to proceed sufficiently with a maximum temperature reached retention time of 60 minutes or shorter. The maximum temperature reached retention time may be 1 minute or longer, and may be 60 minutes or shorter, 40 minutes or shorter, or 30 minutes or shorter, from the viewpoint of volatilizing all the volatile solvent and improving the yield.

In the present embodiment, by using the metal paste of the present embodiment, sintering can be performed at a low temperature of 300°C or lower, 200°C or lower, or 150°C or lower in an atmosphere containing formic acid gas, and firing may be performed at 100 to 300°C, 100 to 200°C, or 100 to 150°C. Even in this case, conductive vias having excellent conductivity and connection reliability can be formed.

The firing of the metal sintered body precursor may be performed without pressurization or may be performed in a state where pressure is applied. In the latter case, in an atmosphere containing a pure hydrogen gas, the pressure may be 0.05 MPa or more, 0.1 MPa or more, or 0.3 MPa or more, and may be 20 MPa or less, 15 MPa or less, or 10 MPa or less. In addition, in an atmosphere containing nitrogen gas, the pressure may be 1 MPa or more or 3 MPa or more, and may be 20 MPa or less, 15 MPa or less, or 10 MPa or less.

By setting the pressure to 0.05 MPa or more when the pure hydrogen gas is used and 1 MPa or more when nitrogen gas is used, the occurrence of voids in the conductive via formed in the central part of the through-hole 30 is easily suppressed, and a conductive via having excellent conductivity is easily obtained. In addition, by setting the pressure to the above-described lower limit value or more, when the silicon substrate 40 includes the metal coating 2, the bonding strength between the metal coating 2 and the conductive via is easily improved.

In addition, when the pressure applied during firing is within the range described above, a special pressurizing device is unnecessary, and thus the reduction of voids, the bonding strength, and the connection reliability can be further improved without impairing the yield. Examples of a method of applying pressure to the silicon substrate in which the metal sintered body precursor is formed in the through-holes include a method of placing a weight, a method of applying pressure using a pressurizing device, and a method of applying pressure using a fixing jig for applying pressure.

When the metal sintered body is a copper sintered body, the ratio of the copper element among the constituent elements, excluding light elements, may be 95% by mass or more, 97% by mass or more, 98% by mass or more, or 100% by mass. When the ratio of the copper element in the copper sintered body is within the above-described range, it is possible to suppress the formation of an intermetallic compound or the precipitation of foreign elements on the grain boundaries of metal copper crystals, the properties of the metal copper constituting the copper sintered body are easily enhanced, and more excellent connection reliability is easily obtained.

In step d, since the conductive via precursor has an exposed surface VP₁ that is planarized and has a sufficiently small step height with respect to the substrate surface, and further has a composition that is less likely to undergo volume shrinkage by firing, the step height between the surface SP₀ of the substrate 40 and the exposed surface VP₂ of the conductive via 3c can be sufficiently reduced.

The step height (or a recess of the conductive via 3c) between the surface SP₀ of the substrate 40 and the exposed surface VP₂ of the conductive via 3c may be 5 µm or less or 3 µm or less in a direction perpendicular to the substrate surface. In addition, the average step height calculated by the following method may fall within the above-described range.

### (Average Step Height)

The average step height is calculated by acquiring an image of a cross-section passing through the center of a hole (via), binarizing the cross-section image to obtain a cross-sectional area Sb surrounded by the inner walls of the hole (via), the exposed surface of the conductive via, and the opening surface of the hole (via), and dividing the cross-sectional area Sb by the interval Wb between the inner walls of the hole.

The substrate with conductive vias 50 can be obtained through the above-described steps a to d. In the substrate with conductive vias 50, since the exposed surface of the conductive via is planarized (or smoothed) and the step height with respect to the surface SP₀ of the substrate 40 is sufficiently small, it is easy to form a wiring, and a sufficiently low connection resistance value can be exhibited even after the wiring is formed.

In addition, a metal coating may be further formed on the surface of the substrate 50 with a metal sintered body obtained through the steps a to d described above. Examples of the metal coating include titanium, nickel, chromium, copper, aluminum, palladium, platinum, and gold. From the viewpoint of adhesion and etching in a subsequent step, the metal coating is preferably copper. The metal coating can be formed by plating or sputtering, and sputtering is more preferred. In this case, penetration of chemicals into the copper sintered body having a porous structure can be prevented in the resist formation step, the plating step, the resist removal step, and the etching step described later, thereby suppressing oxidation of the copper sintered body and improving reliability.

### [Step S2]

In step S2, a resin-containing part containing a photosensitive resin composition or a cured product thereof is provided in the metal sintered body of the substrate with a metal sintered body. In addition, the metal sintered body may be provided with the resin-containing part and a resin-free part not containing a resin composition or a cured product thereof such that the resin-containing part is localized on the opening side. In this case, it is possible to prevent adverse effects caused by penetration of chemicals and the like during wiring formation in a subsequent step while suppressing an increase in connection resistance value due to the resin-containing part.

The photosensitive resin composition may be any composition capable of forming a predetermined pattern by exposure and development, and may be a negative type or a positive type.

Examples of a method for providing the resin-containing part containing the photosensitive resin composition in the metal sintered body include a method of laminating a film-shaped photosensitive resin composition or a method of applying a liquid photosensitive resin composition. In the case of providing the resin-containing part containing a cured product of the photosensitive resin composition in the metal sintered body, the photosensitive resin composition can be cured after providing the resin-containing part containing the photosensitive resin composition. In this case, the photosensitive resin composition may contain a thermosetting component and be capable of being thermally cured.

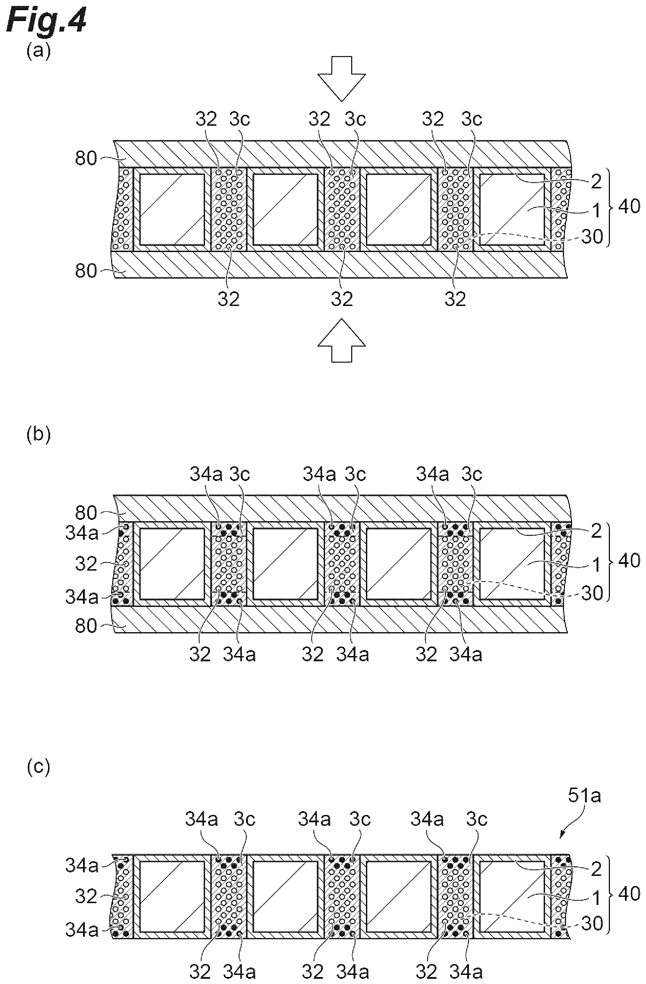

Step S2 may include: step S2-1a of impregnating at least a part of the metal sintered body 3c with a negative-type photosensitive resin composition by laminating a film-shaped negative-type photosensitive resin composition 80 onto a surface of the substrate with a metal sintered body (see FIGS. 4(a) and 4(b)); and step S2-2a of, after step S2-1a, removing the film-shaped negative-type photosensitive resin composition by a development treatment to expose the metal sintered body 3c having the resin-containing part containing the negative-type photosensitive resin composition 34a at the openings of the holes (see FIG. 4(c)).

As the film-shaped negative-type photosensitive resin composition, dry film resists such as a photocurable dry film resist and a thermosetting dry film resist can be used, and commercially available products such as RD-1619 (trade name, manufactured by Resonac Corporation), HM-4035 (trade name, manufactured by Resonac Corporation), HM-4056 (trade name, manufactured by Resonac Corporation), TMMF NA1000 (trade name, manufactured by Tokyo Ohka Kogyo Co., Ltd.), and PSR-800 AUS SR-1 (trade name, manufactured by TAIYO INK MFG. CO., LTD.) may also be used.

Examples of the method for laminating the film-shaped negative photosensitive resin composition include methods using a roll laminator, a laminator, a press, and the like.

The pressure may be 0.1 MPa or more, 0.4 MPa or more, or 1 MPa or more from the viewpoint of facilitating impregnation of the metal sintered body with the photosensitive resin composition. The upper limit of the pressure may be 10 MPa or less from the viewpoint of reducing the influence on the substrate.

From the viewpoint of facilitating impregnation of the metal sintered body with the photosensitive resin composition, lamination may be performed while heating. The heating temperature is not particularly limited as long as the photosensitive resin composition does not cure, and may be 50°C to 100°C or 70°C to 90°C.

From the viewpoint of facilitating impregnation of the metal sintered body with the photosensitive resin composition, the film-shaped negative-type photosensitive resin composition may be laminated after maintaining a degree of vacuum of 1,000 Pa or less or a degree of vacuum of 200 Pa or less.

The depth with which the metal sintered body is impregnated with the photosensitive resin composition may be 0.2% or more, 0.5% or more, or 1% or more with respect to the total length of the metal sintered body in the thickness direction of the substrate from the viewpoint of connection reliability, and the distance from the exposed surface of the metal sintered body may be 1 µm or more, 2 µm or more, or 3 µm or more.

In S2-2a, a development treatment corresponding to the photosensitive resin composition can be performed. As the developer, for example, an alkaline aqueous solution obtained by dissolving an alkaline compound such as sodium carbonate, sodium hydroxide, potassium hydroxide, tetramethylammonium hydroxide, or choline in water to a concentration of about 1 to 10 mass%, an alkaline aqueous solution such as aqueous ammonia, or the like can be used. Examples of the development method include a shower development method, a spray development method, an immersion development method, and a paddle development method.

Through step S2-2a, a substrate 51a with conductive vias is obtained (see FIG. 4(c)).

Step S2 may further include step S2-3a of curing the negative-type photosensitive resin composition contained in the resin-containing part after step S2-2a.

In the case of photocuring, examples of the actinic ray used for exposure include: a light beam using a g-line stepper as a light source; ultraviolet rays using a low-pressure mercury lamp, a high-pressure mercury lamp, a metal halide lamp, an i-line stepper, or the like as a light source; an electron beam; a laser beam; or the like can be used. The exposure amount is appropriately selected depending on the light source used, the thickness of the impregnated photosensitive resin composition, and the like.

When the negative-type photosensitive resin composition contains a thermosetting component, thermosetting may be performed.

Step S2 may further include step S2-4a of performing a desmear treatment on at least the exposed surface of the metal sintered body after step S2-3a.

Examples of the desmear treatment include plasma cleaning and treatment with a desmear solution containing a permanganate and a caustic composition (for example, an alkali metal hydroxide or the like).

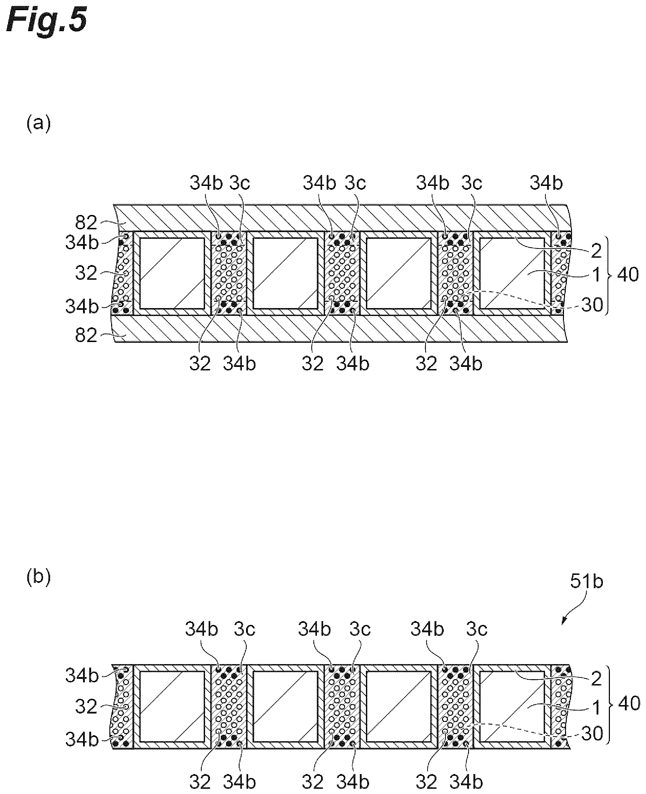

As another aspect, step S2 may include: step S2-1b of impregnating at least a part of the metal sintered body 3c with a negative-type photosensitive resin composition by applying a liquid negative-type photosensitive resin composition 82 onto a surface of the substrate with a metal sintered body (see FIG. 5(a)); and step S2-2b of, after step S2-1b, removing the coating film of the liquid negative-type photosensitive resin composition by a development treatment to expose the metal sintered body 3c having the resin-containing part containing the negative-type photosensitive resin composition 34b at the openings of the holes (see FIG. 5(b)).

As the liquid negative-type photosensitive composition, for example, commercially available products such as PSR-4000 G24K/CA-40 G24 (trade name, manufactured by TAIYO INK MFG. CO., LTD.), TER-20HF (trade name, manufactured by TAIYO INK MFG. CO., LTD.), and TMMR NA1000PM (trade name, manufactured by Tokyo Ohka Kogyo Co., Ltd.) may be used.

Examples of the method for applying the liquid negative-type photosensitive composition include screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, and a dip coater. From the viewpoint of the workability of coating and the uniformity of the coating film thickness, coating may be performed by screen printing or spin coating.

The depth with which the metal sintered body is impregnated with the photosensitive resin composition and the method for developing the coating film of the liquid negative-type photosensitive resin composition may be the same as those in the above-described step S2-1a and step S2-2a.

Through step S2-2b, a substrate 51b with conductive vias is obtained (see FIG. 5(b)).

In addition, after step S2-2b, similarly to the above-described step S2-3a and step S2-4step S2-3b of curing the negative-type photosensitive resin composition contained in the resin-containing part may be performed, and after step S2-3b, step S2-4b of performing a desmear treatment on at least the exposed surface of the metal sintered body may be performed.

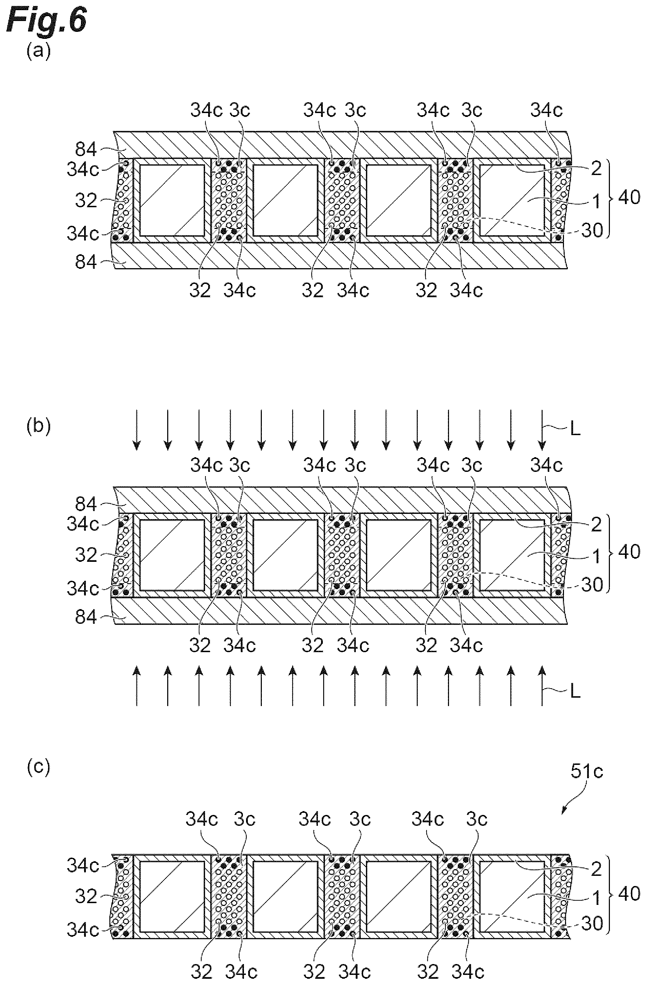

As another aspect, step S2 may include: step S2-1c of impregnating at least a part of the metal sintered body with a positive-type photosensitive resin composition by applying a liquid positive-type photosensitive resin composition onto a surface of the substrate with a metal sintered body or by laminating a film-shaped positive-type photosensitive resin composition onto a surface of the substrate with a metal sintered body (see FIG. 6(a)); and step S2-2c of, after step S2-1c, removing the coating film of the liquid positive-type photosensitive resin composition or the film-shaped positive-type photosensitive resin composition by exposure and a development treatment to expose the metal sintered body having the resin-containing part containing the positive-type photosensitive resin composition at the openings of the holes (see FIGS. 6(b) and 6(c)).

As the positive-type photosensitive composition, for example, commercially available products such as AH-3000 (trade name, manufactured by Resonac Corporation), AR-5100 (trade name, manufactured by Resonac Corporation), and OFPR-8600 (trade name, manufactured by Tokyo Ohka Kogyo Co., Ltd.) may also be used.

For the application of the photosensitive composition and the lamination of the photosensitive composition, the methods described above can be used.

The depth with which the metal sintered body is impregnated with the photosensitive resin composition may be the same as that in the above-described step S2-1a.

The exposure in step S2-2c can be performed using, for example, a light beam using a g-line stepper as a light source; ultraviolet rays using a low-pressure mercury lamp, a high-pressure mercury lamp, a metal halide lamp, an i-line stepper, or the like as a light source; an electron beam; a laser beam; and the like. The exposure amount is appropriately selected depending on the light source used, the thickness of the impregnated photosensitive resin composition, and the like.

The method for developing the coating film of the liquid positive-type photosensitive resin composition and the film-shaped positive-type photosensitive resin composition may be the same as that in the above-described step S2-2a.

Through step S2-2c, a substrate 51c with conductive vias is obtained (see FIG. 5(c)).

In addition, when the positive-type photosensitive resin composition contains a thermosetting component, step S2-3c of thermally curing the positive-type photosensitive resin composition contained in the resin-containing part may be performed after step S2-2c. Further, after step S2-3c, similarly to the above-described step S2-4a, step S2-4c of performing a desmear treatment on at least the exposed surface of the metal sintered body may be performed.

### <Method for Manufacturing Wiring Board with Conductive Vias>

The method for manufacturing a wiring board with conductive vias according to the present embodiment includes step S3 of forming a wiring electrically connected to the conductive vias on the substrate with conductive vias obtained by the method for manufacturing a substrate with conductive vias according to the present embodiment.

The step S3 can include a resist formation step, a plating step, a resist removal step, and an etching step described below.

### <Resist Formation Step>

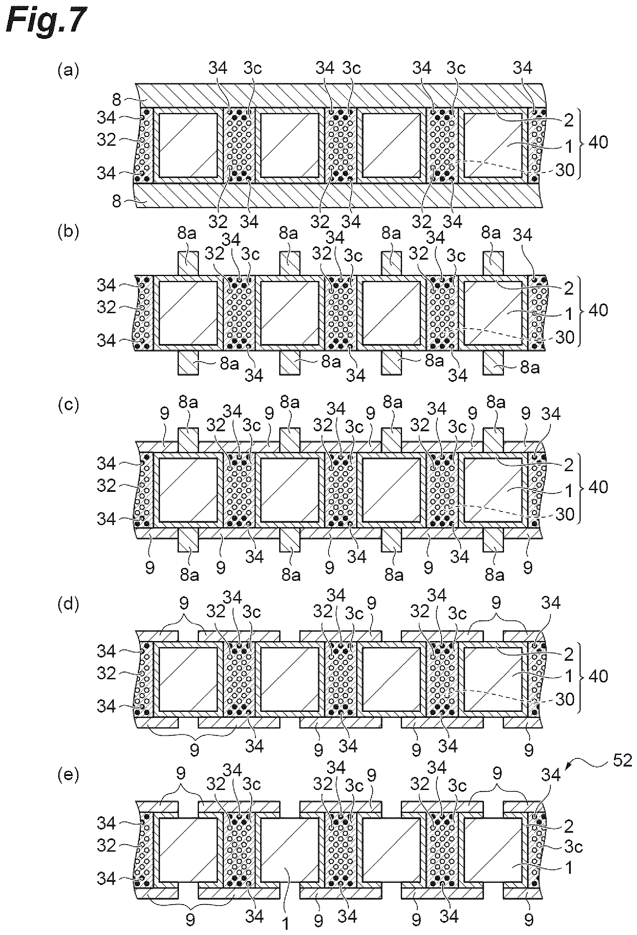

In the resist formation step, for example, as illustrated in FIGS. 7(a) and 7(b), a negative photosensitive dry film 8 for an etching resist is laminated on the main surface of the silicon substrate 40 and the conductive vias, a photomask that transmits light in a wiring shape is then superimposed, exposure is performed with ultraviolet rays, and an unexposed part is removed with a developer, whereby etching resists 8a can be formed.

Examples of a method for forming the etching resists 8a other than the above include a method of silk-screen printing a resist ink and a method of bonding a dry film resist with a laminator.

When the substrate with conductive vias is obtained through step S2 having step S2-1a and step S2-2a, the etching resist 8a may be formed by irradiating the film-shaped negative-type photosensitive resin composition with light in a wiring shape before step S2-2a.

### <Plating Step>

In the plating step, for example, as illustrated in FIG. 7(c), a wiring 9 can be formed in the openings of the etching resists 8a by a method such as electrolytic plating or electroless plating.

### <Resist Removing Step>

In the resist removing step, for example, as illustrated in FIG. 7(d), the etching resists 8a can be removed by a method such as stripping by a wet process using an alkaline aqueous solution or an organic solvent-based chemical solution such as an organic amine-based chemical solution such as TMAH or a ketone-based chemical solution such as acetone, or stripping by a dry process such as plasma or ozone.

### <Etching Step>

In the etching step, the metal coating 2 at a part not covered with the wiring 9 can be removed by etching. In the present embodiment, a part of the metal coating 2 provided on both main surfaces of the silicon wafer 1 is removed by etching.

Examples of the etching method include methods using a chemical etching solution used for a normal wiring board, such as a solution of cupric chloride and hydrochloric acid, a ferric chloride solution, a solution of sulfuric acid and hydrogen peroxide, or an ammonium persulfate solution.

A wiring board with conductive vias 52 as illustrated in FIG. 7(e) can be obtained by the step e described above,

Note that, in the method described above, a step of removing at least a part of conductors such as a sintered body of a metal paste and the metal coating 2 remaining on the main surface of the silicon substrate 40 may be provided before step e.

Examples of means for removing the conductor include chemical polishing, mechanical polishing, chemical mechanical polishing, a fly cutting treatment, and a plasma treatment. The fly cutting treatment means cutting planarization by a surface planer.

According to the method of the present embodiment for manufacturing a wiring board with conductive vias, by providing a wiring on the substrate with conductive vias of the present embodiment, a wiring board with conductive vias that exhibits a sufficiently low connection resistance value and has excellent connection reliability can be obtained.

### <Substrate with Conductive Vias>

The substrate with conductive vias of the present embodiment includes a substrate having through-holes and conductive vias provided in the through-holes, wherein the conductive vias include a metal sintered body having a porous structure, and the metal sintered body includes a resin-containing part containing a photosensitive resin composition or a cured product thereof.

The substrate with conductive vias of the present embodiment can be obtained by the method for manufacturing a substrate with conductive vias of the present embodiment described above.

### <Wiring Board with Conductive Vias>

The wiring board with conductive vias of the present embodiment includes the substrate with conductive vias of the present embodiment and a wiring provided on the substrate with conductive vias and electrically connected to the conductive vias.

The wiring board with conductive vias of the present embodiment can be obtained by the above-described method of the present embodiment for manufacturing a wiring board with conductive vias, and can exhibit a sufficiently low connection resistance value and have excellent connection reliability.

### [Examples]

Hereinafter, the present invention will be described in more detail with reference to Examples and Comparative Examples, but the present invention is not limited to the following Examples.

### [Preparation of Metal Paste]

### (Preparation Examples A to J)

The following raw materials were mixed in the ratios shown in Tables 1 and 2 using a three-roll mill to prepare metal pastes, respectively.

### <First Copper Particles>

### (Wet Copper Powder)

Spherical copper particles W1: 1050Y (manufactured by MITSUI MINING & SMELTING CO., LTD., average particle diameter (D50): 0.81 µm, spherical shape)
Spherical copper particles W4: 1300Y (manufactured by MITSUI MINING & SMELTING CO., LTD., average particle diameter (D50): 3.5 µm, spherical shape)
Flat copper particles W2: 1200YP (manufactured by MITSUI MINING & SMELTING CO., LTD., average particle diameter (D50): 3.1 µm, flat shape)

### (Atomized Copper Powder)

Spherical copper particles A2: MA-C025K (manufactured by MITSUI MINING & SMELTING CO., LTD., average particle diameter (D50): 2.4 µm, spherical shape)

### <Second Copper Particles>

Spherical copper particles W5: CH0200L1 (manufactured by MITSUI MINING & SMELTING CO., LTD., average particle diameter (D50): 200 nm, spherical shape)

### <Solder Particles>

Solder particles 1: SnBi58 solder STC-3 (manufactured by MITSUI MINING & SMELTING CO., LTD., average particle diameter (D50): 4.1 µm, spherical shape)
Solder particles 2: Sn96.5Ag3Cu0.5 solder STC-3 (manufactured by MITSUI MINING & SMELTING CO., LTD., average particle diameter (D50): 4.1 µm, spherical shape)

### <Nickel Particles>

Nickel particles 1: nickel nanoparticles (manufactured by EM Japan Co., Ltd., average particle diameter (D50): 0.1 µm, spherical shape)
Nickel particles 2: nickel particles (manufactured by METAL FOIL & POWDERS MFG CO., average particle diameter (D50): 3.0 µm, spherical shape)

### <Silver Particles>

Silver particles 1: OS silver fine particles (manufactured by Osaka Soda Co., Ltd., average particle diameter (D50): 0.2 µm, spherical shape)
Silver particles 2: NP-AG-15 (manufactured by EM Japan Co., Ltd., average particle diameter (D50): 3 µm, spherical shape)
Silver particles 3: AgC-271B (manufactured by Fukuda Metal Foil & Powder Co., Ltd., average particle diameter (D50): 2.1 µm, flat shape)

### <Silver-Coated Copper Particles>

Silver-coated copper particles 1: 10% Ag-coated Cu-HWQ5µm (manufactured by Fukuda Metal Foil & Powder Co., Ltd., average particle diameter (D50): 5.9 µm, spherical shape)
Silver-coated copper particles 2: 10% Ag-coated 2L3 (manufactured by Fukuda Metal Foil & Powder Co., Ltd., average particle diameter (D50): 10.9 µm, flat shape)

### <Resin Component>

Resin R1: a mixture of "KFA-2000" (manufactured by Goo Chemical Co., Ltd., an acrylic-based binder) as an organic binder and a mixture of carbitol and terpineol as an organic solvent (mass ratio of carbitol to terpineol in the mixture [carbitol:terpineol] = 1:1) mixed at a mass ratio of 1:2

### <Volatile Solvent>

(High Vapor Pressure Solvent: vapor pressure of 4 Pa or More and 30 Pa or Less at 20°C)
α-Terpineol: manufactured by FUJIFILM Wako Pure Chemical Corporation, vapor pressure of 6.5 Pa at 20°C
(Low Vapor Pressure Solvent: vapor pressure of less than 4 Pa at 20°C)
Isobornyl cyclohexanol: trade name "Terusolve MTPH," manufactured by NIPPON TERPENE CHEMICALS, INC., vapor pressure of 0.004 Pa at 20°C
Diethylene glycol mono-n-butyl ether: manufactured by Showa Chemical Industry Co., Ltd., vapor pressure 1.3 Pa at 20°C

**[Table 1]**

| | | | | | Preparation Example A | Preparation Example B | Preparation Example C | Preparation Example D | Preparation Example E | Preparation Example F | Preparation Example G |
|---|---|---|---|---|---|---|---|---|---|---|---|
| | Copper particles | First copper particles | Wet copper powder | Spherical copper particles W1 | - | - | - | - | - | - | - |
| | | | | Spherical copper particles W4 | 20 | - | 20 | 20 | 20 | - | - |
| | | | | Flat copper particles W2 | 20 | 50 | 20 | 20 | 20 | 20 | - |
| | | | Atomized copper powder | Spherical copper particles A2 | 20 | 10 | 20 | 20 | 20 | 20 | - |
| | | Second copper particles | Wet copper powder | Spherical copper particles W5 | 30 | 30 | 27 | 27 | 15 | 30 | - |
| | Solder particles | Solder particles 1 | | | - | - | 3 | - | - | - | - |
| | | Solder particles 2 | | | - | - | - | 3 | - | - | - |
| | Nickel particles | Nickel particles 1 | | | - | - | - | - | 15 | - | - |
| Composition | | Nickel particles 2 | | | - | - | - | - | - | 20 | - |
| | Silver particles | Silver particles 1 | | | - | - | - | - | - | - | 30 |
| | | Silver particles 2 | | | - | - | - | - | - | - | 30 |
| | | Silver particles 3 | | | - | - | - | - | - | - | 30 |
| | Silver-coated copper particles | Silver-coated copper particles 1 | | | - | - | - | - | - | - | - |
| | | Silver-coated copper particles 2 | | | - | - | - | - | - | - | - |
| | Resin component | Resin R1 | | | - | - | - | - | - | - | - |
| | Volatile solvent | High vapor pressure solvent | α-Terpineol (6.5 Pa) | | 2 | 2 | 2 | 2 | 2 | 2 | 2 |
| | | Low vapor pressure solvent | Diethylene glycol mono-n-butyl ether | | 2 | 2 | 2 | 2 | 2 | 2 | 2 |

**[Table 2]**

| | | | | | Preparation Example H | Preparation Example I | Preparation Example J |
|---|---|---|---|---|---|---|---|
| | Copper particles | First copper particles | Wet copper powder | Spherical copper particles W1 | - | - | 30 |
| | | | | Spherical copper particles W4 | 20 | 20 | - |
| | | | | Flat copper particles W2 | 10 | 10 | - |
| | | | Atomized copper powder | Spherical copper particles A2 | 20 | 20 | 30 |
| | | Second copper particles | Wet copper powder | Spherical copper particles W5 | 30 | 30 | 30 |
| | Solder particles | Solder particles 1 | | | - | - | - |
| | | Solder particles 2 | | | - | - | - |
| Composition | Nickel particles | Nickel particles 1 | | | - | - | - |
| | | Nickel particles 2 | | | - | - | - |
| | Silver particles | Silver particles 1 | | | - | - | - |
| | | Silver particles 2 | | | - | - | - |
| | | Silver particles 3 | | | - | - | - |
| | Silver-coated copper particles | Silver-coated copper particles 1 | | | 10 | - | - |
| | | Silver-coated copper particles 2 | | | - | 10 | - |
| | Resin component | Resin R1 | | | - | - | 5 |
| | Volatile solvent | High vapor pressure solvent | α-Terpineol (6.5 Pa) | | 2 | 2 | - |
| | | Low vapor pressure solvent | Diethylene glycol mono-n-butyl ether | | 2 | 2 | - |

### [Production of Glass Substrate with Conductive Vias]

### (Examples 1 to 32 and Comparative Examples 1 to 9)

Glass substrates with conductive vias were produced by the following procedure.

### <Preparation of Glass Substrate>

A glass substrate "D263Teco" (trade name, manufactured by SCHOTT AG, material: borosilicate glass, average linear thermal expansion coefficient α: 7.2 × 10⁻⁶ K-1) provided with through-holes and having a titanium layer (thickness: 100 nm) and a copper layer (thickness: 300 nm) formed in this order on both main surfaces and on the wall surfaces of the through-holes was prepared. Note that the glass substrate has a diameter of 6 inches and a thickness of 300 µm, and the titanium layer and the copper layer described above were sequentially formed by sputtering. Substrates provided with through-holes having hole diameters (via diameters) of 50, 90, 150, and 200 µm were prepared, respectively.

### <Preparation of Metal Particle Film>

The metal paste of Preparation Example A prepared above was printed on a PET film having a thickness of 100 µm with a screen printer in a size of 8 inch-Ø (circular shape with a diameter of 20 cm) using a screen printing plate (wire diameter: 23 µm, number of meshes: 400, mesh size: 41 µm, space ratio: 41 µm) to obtain a metal particle film provided with a metal particle-containing layer.

### <Formation of Metal Sintered Body>

Using a bonding apparatus VJ-35 (manufactured by Ayumi Industry Co., Ltd.), the metal particle film was bonded to the glass substrate from the metal particle-containing layer side, and the laminate was further vacuum-pressed at room temperature at a pressure of 3 MPa to fill the through-holes with the metal paste. At this time, the metal paste was caused to protrude on the side of the glass substrate opposite to the side on which the metal particle film was bonded.

Subsequently, the laminate from which the PET film had been peeled off was dried in the air at 90°C for 10 minutes. Note that the concentrations (mass%) of the metal particles in the metal paste part before and after drying were 95.7 mass% and 97.8 mass%, respectively.

For the dried laminate, as illustrated in FIGS. 3(a) to 3(d), the metal paste on the main surface of the glass substrate on the side on which the metal particle film was bonded was removed using a rubber squeegee, and subsequently, the metal paste protruding on the side of the glass substrate opposite to the side on which the metal particle film was bonded was removed using the rubber squeegee.

Subsequently, the glass substrate having the metal sintered body precursors formed in the through-holes by the above-described steps was placed in a tube furnace (manufactured by AVC Co., LTD.), and an argon gas was caused to flow at 1 L/min to replace the air in the tube furnace with the argon gas. Thereafter, the temperature was increased to 300°C over 10 minutes while a hydrogen gas flowed at 300 mL/min, and a sintering treatment was carried out at 300°C for 60 minutes to sinter the metal sintered body precursor. Thereafter, the resulting product was cooled by flowing an argon gas at a flow rate of 0.3 L/min and taken out into the air at 50°C or lower to obtain a glass substrate with a metal sintered body.

For the glass substrate with a metal sintered body obtained above, the porosity of the metal sintered body was evaluated according to the following method.

### (Porosity of Metal Sintered Body)

The glass substrate with a metal sintered body subjected to mechanical polishing was cut in the thickness direction, and the cross-section of the central part of the metal sintered body of the glass substrate was exposed by a focused ion beam, and the cross section was observed. When observing the cross-section of the central part of the through-hole of the glass substrate, a range of ±5 µm in the thickness direction of the glass substrate and ±5 µm in the direction perpendicular to the thickness direction of the glass substrate from the center part of the through-hole was observed. A focused ion beam machining observation device MI4050 (manufactured by Hitachi High-Technologies Corporation) was used. For the observation, a scanning electron microscope S-3700N (manufactured by Hitachi High-Technologies Corporation) was used at a magnification of 5,000 times, and a cross-section image (approximately 10 µm square) of the metal sintered body was captured. The number of observation points was 5. The obtained cross-section images were binarized using image analysis software (Adobe Photoshop (registered trademark) Elements) so that the sintered copper part and the porous (void) part were separated. For each of the 5 observation points, the ratio of the area of the porous (void) part to the total area of the cross section of the metal sintered body was determined, and this was taken as the porosity. The mean value of the porosities at the 5 observation points was taken as the porosity of the metal sintered body. For the observation, a scanning electron microscope S-3700N (manufactured by Hitachi High-Technologies Corporation) was used at a magnification of 5,000 times, and a cross-section image (approximately 10 µm square) of the metal sintered body was captured.

### [Production of Wiring Board]

### (Examples 1 to 4)

Conductive vias having a resin-containing part containing a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

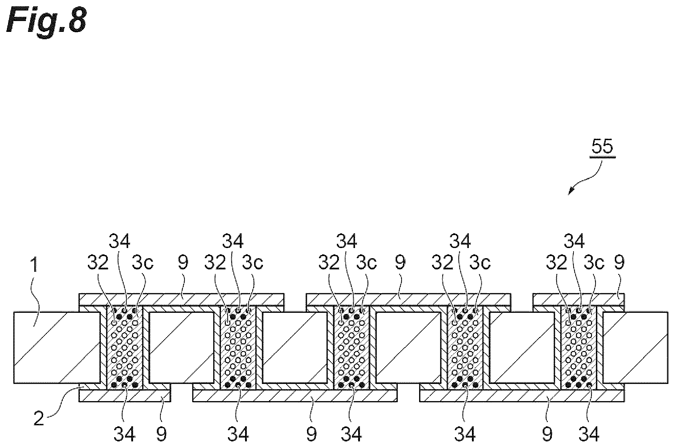

A dry film "RD-1619" (trade name, manufactured by Resonac Corporation) for an ultraviolet curable etching resist (photosensitive resin composition F1) was laminated onto the surface of the glass substrate with a metal sintered body obtained above by atmospheric pressure lamination under conditions of a roll pressure of 0.4 MPa, a processing temperature of 120°C, and a conveyance speed of 1.0 m/s to form a dry film resist layer. Next, the dry film resist layer was exposed in a predetermined pattern using a direct imaging exposure machine "DE-1UH" (product number, manufactured by Via Mechanics, Ltd.) under conditions of 55 mJ/cm². One minute later, a PEB (Post Exposure Bake) treatment was performed at 70°C for 1 minute, followed by treatment with a developer of sodium carbonate at a concentration of 1% at a spray pressure of 0.17 MPa at 30°C for 70 seconds, and residues were further removed by oxygen plasma treatment to form a resist pattern. After surface treatment by etching treatment (ammonium persulfate: 100 g/L, R.T., 30 seconds) and sulfuric acid aqueous solution (100 g/L, R.T., 30 seconds), electrolytic plating was performed on the resist openings. Thereafter, through resist stripping and seed layer etching, a wiring having a wiring pattern of 300 µm x 600 µm was formed, thereby obtaining a test piece 55 (wiring board) as illustrated in FIG. 8. Note that the wiring pattern was finished to have a thickness of approximately 10 µm after seed layer etching. In the test piece 55, the conductive vias formed in the through-holes are electrically connected by the wiring provided on the substrate surface.

### (Examples 5 to 8)

Wiring boards were obtained and evaluated in the same manner as in Examples 1 to 4, except that the roll pressure of the dry film "RD-1619" was changed to 1.0 MPa.

### (Examples 9 to 12)

Wiring boards were obtained and evaluated in the same manner as in Examples 1 to 4, except that the roll pressure of the dry film "RD-1619" was changed to 3.0 MPa.

### (Examples 13 to 16)

Conductive vias having a resin-containing part containing a cured product of a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A photosensitive film type TMMF NA1000 (trade name, manufactured by Tokyo Ohka Kogyo Co., Ltd.) (photosensitive resin composition F2) was laminated onto the surface of the glass substrate with a metal sintered body obtained above by atmospheric pressure lamination under conditions of a roll pressure of 1.0 MPa, a processing temperature of 120°C, and a conveyance speed of 1.0 m/s to form a dry film resist layer. Next, a PEB treatment was performed at 80°C for 5 minutes, followed by treatment with PEGMEA (developer) at a spray pressure of 0.17 MPa at 30°C for 1 minute, and the dry film resist layer formed on the glass substrate surface was entirely stripped. Next, a heat treatment was performed at 200°C for 2 minutes to cure the photosensitive resin composition (TMMF NA1000) impregnated into the porous part of the copper sintered body. Furthermore, residues of the photosensitive resin composition and its cured product remaining on the surface of the copper sintered body were removed by oxygen plasma treatment.

### [Wiring Formation Step A]

A dry film "RD-1619" (trade name, manufactured by Resonac Corporation) for an ultraviolet curable etching resist was laminated onto the surface of the substrate with conductive vias obtained above by atmospheric pressure lamination under conditions of a roll pressure of 0.4 MPa, a processing temperature of 120°C, and a conveyance speed of 1.0 m/s to form a dry film resist layer. Next, the dry film resist layer was exposed in a predetermined pattern using a direct imaging exposure machine "DE-1UH" (product number, manufactured by Via Mechanics, Ltd.) under conditions of 55 mJ/cm². One minute later, a PEB treatment was performed at 70°C for 1 minute, followed by treatment with a developer of sodium carbonate at a concentration of 1% at a spray pressure of 0.17 MPa at 30°C for 70 seconds, and residues were further removed by oxygen plasma treatment to form a resist pattern. Next, after electrolytic plating was performed on the resist openings, through resist stripping and seed layer etching, a wiring having a wiring pattern of 300 µm × 600 µm was formed, thereby obtaining a test piece 55 (wiring board) as illustrated in FIG. 8. Note that the wiring pattern was finished to have a thickness of approximately 10 µm after seed layer etching. In the test piece 55, conductive vias formed in the through-holes were electrically connected by the wiring provided on the substrate surface.

### (Examples 17 to 20)

Conductive vias having a resin-containing part containing a cured product of a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A developable dry film solder resist PSR-800 AUS SR-1 (trade name, manufactured by TAIYO INK MFG. CO., LTD.) (photosensitive resin composition F3) was laminated onto the surface of the glass substrate with a metal sintered body obtained above using a vacuum laminator MVLP series (trade name, manufactured by The Japan Steel Works, Ltd.) under conditions of 100°C, 0.5 MPa, and a cycle time of 30 seconds after a cycle time of 30 seconds at a vacuum degree of 3 hPa, and then a press treatment was performed under conditions of 80°C, 0.8 MPa, and a cycle time of 60 seconds. Next, a development treatment was performed with a 1 mass% sodium carbonate solution at 30°C, a spray pressure of 0.15 MPa, for 1 minute, and water washing was performed at 25°C, a spray pressure of 0.10 MPa, for 1 minute. The dry film resist layer formed on the glass substrate surface was entirely stripped. Next, post-curing was performed at 150°C for 60 minutes to cure the photosensitive resin composition (PSR-800 AUS SR-1) impregnated into the porous part of the copper sintered body. Furthermore, residues of the photosensitive resin composition and its cured product remaining on the surface of the copper sintered body were removed by oxygen plasma treatment.

Wirings were formed on the surface of the glass substrate with conductive vias obtained above in the same manner as in the above-described Wiring Formation Step A, thereby obtaining a test piece 55 (wiring board) as illustrated in FIG. 8.

### (Examples 21 to 24)

Conductive vias having a resin-containing part containing a cured product of a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A developable screen-printing solder resist PSR-4000 G24K/CA-40 G24 (trade name, manufactured by TAIYO INK MFG. CO., LTD.) (photosensitive resin composition L1) was printed on one surface of the glass substrate with a metal sintered body obtained above using a screen printer to a thickness of approximately 20 µm. After pre-drying at 80°C for 30 minutes, the other surface was similarly printed using a screen printer to a thickness of approximately 20 µm, and pre-drying was performed at 80°C for 30 minutes. Next, a development treatment was performed with a 1 mass% sodium carbonate solution at 30°C, a spray pressure of 0.15 MPa, for 1 minute, and water washing was performed at 25°C, a spray pressure of 0.10 MPa, for 1 minute. The solder resist layer formed on the glass substrate surface was entirely stripped. Next, post-curing was performed at 150°C for 60 minutes to cure the photosensitive resin composition (PSR-4000 G24K/CA-40 G24) impregnated into the porous part of the copper sintered body. Furthermore, residues of the photosensitive resin composition and its cured product remaining on the surface of the copper sintered body were removed by oxygen plasma treatment.

Wirings were formed on the surface of the glass substrate with conductive vias obtained above in the same manner as in the above-described Wiring Formation Step A, thereby obtaining a test piece 55 (wiring board) as illustrated in FIG. 8.

### (Examples 25 to 28)

Conductive vias having a resin-containing part containing a cured product of a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A positive-type photosensitive resin AH-3000 (trade name, manufactured by Resonac Corporation) (photosensitive resin composition L2) was applied onto one surface of the glass substrate with a metal sintered body obtained above by spin coating at 1,000 rpm for 5 seconds and 2,000 rpm for 20 seconds to a thickness of approximately 5 µm. After pre-drying at 120°C for 150 seconds, the other surface was similarly processed by spin coating at 1,000 rpm for 5 seconds and 2,000 rpm for 20 seconds to a thickness of approximately 5 µm. Both surfaces of the substrate were entirely exposed using a direct imaging exposure machine "DE-1UH" (product number, manufactured by Via Mechanics, Ltd.) under conditions of 500 mJ/cm². Subsequently, treatment was performed with 2.38%-TMAH (developer) at a spray pressure of 0.17 MPa at 30°C for 1 minute, and the positive-type photosensitive resin composition layer formed on the glass substrate surface was entirely stripped. Next, a heat treatment was performed at 230°C for 60 minutes to cure the positive-type photosensitive resin composition (AH-3000) impregnated into the porous part of the copper sintered body. Furthermore, residues of the photosensitive resin composition and its cured product remaining on the surface of the copper sintered body were removed by oxygen plasma treatment.

Wirings were formed on the surface of the glass substrate with conductive vias obtained above in the same manner as in the above-described Wiring Formation Step A, thereby obtaining a test piece 55 (wiring board) as illustrated in FIG. 8.

### (Examples 29 to 32)

Conductive vias having a resin-containing part containing a cured product of a photosensitive resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A positive-type photosensitive resin AH-3000 (trade name, manufactured by Resonac Corporation) (photosensitive resin composition L2) was applied onto one surface of the glass substrate with conductive vias obtained above by spin coating at 1,000 rpm for 5 seconds to a thickness of approximately 20 µm. Thereafter, the vacuum was drawn to a degree of vacuum of 3 hPa to impregnate the porous part of the copper sintered body with the positive-type photosensitive resin composition (AH-3000). Pre-drying was performed at 120°C for 150 seconds. The other surface was similarly processed by spin coating at 1,000 rpm for 5 seconds to a thickness of approximately 20 µm. Thereafter, the vacuum was drawn to a degree of vacuum of 3 hPa to impregnate the porous part of the copper sintered body with the positive-type photosensitive resin composition (AH-3000). Furthermore, pre-drying was performed at 120°C for 150 seconds. Both surfaces of the substrate were entirely exposed using a direct imaging exposure machine "DE-1UH" (product number, manufactured by Via Mechanics, Ltd.) under conditions of 500 mJ/cm². Subsequently, treatment was performed with 2.38%-TMAH (developer) at a spray pressure of 0.17 MPa at 30°C for 1 minute, and the positive-type photosensitive resin composition layer formed on the glass substrate surface was entirely stripped. Next, heat treatment was performed at 230°C for 60 minutes to cure the positive-type photosensitive resin composition (AH-3000) impregnated into the porous part of the copper sintered body. Furthermore, residues of the photosensitive resin composition and its cured product remaining on the surface of the copper sintered body were removed by oxygen plasma treatment.

Wirings were formed on the surface of the glass substrate with conductive vias obtained above in the same manner as in the above-described Wiring Formation Step A, thereby obtaining a test piece 55 (wiring board) as illustrated in FIG. 8.

### (Comparative Examples 1 to 4)

Wiring boards were obtained and evaluated in the same manner as in Examples 1 to 4, except that the roll pressure of the dry film "RD-1619" was changed to 0.1 MPa and the treatment time in the etching treatment was changed to 5 minutes.

### (Comparative Examples 5 to 8)

Conductive vias having a resin-containing part containing a cured product of a thermosetting resin composition were formed on the glass substrate with a metal sintered body prepared in the same manner as described above (via diameters: 50, 90, 150, and 200 µm) by the following procedure, and wirings were further formed to obtain wiring boards, which were then evaluated.

A curable resin composition shown below was applied onto one surface of the glass substrate with a metal sintered body obtained above using a roll coater. Next, the glass substrate with a metal sintered body was placed in a container, and the inside of the container was evacuated to a gauge pressure of 100 kPa to create a vacuum state. The glass substrate with a metal sintered body was held in the vacuum state for 10 minutes, and then taken out from the container. It was confirmed that the curable resin composition was impregnated into the copper sintered body of the through-holes and that the curable resin composition had reached the surface of the copper sintered body in the through-holes opposite to the surface onto which the curable resin composition was applied. The curable resin composition remaining on the surface of the glass substrate with a metal sintered body onto which the curable resin composition was applied was removed with a rubber spatula. Next, the application and removal of the curable resin composition were performed in the same manner on the surface opposite to the surface onto which the curable resin composition was applied.

### [Curable Resin Composition]

YDF-170 (trade name, manufactured by Tohto Kasei Co., Ltd., bisphenol F-type epoxy resin, epoxy equivalent = 170): 95 parts by mass
2PZ-CN (trade name, manufactured by Shikoku Chemicals Corporation, imidazole compound): 5 parts by mass

The glass substrate with a metal sintered body in which the copper sintered body was impregnated with the curable resin composition was held at 180°C for 1 hour in a nitrogen atmosphere to obtain a glass substrate with conductive vias having through-electrodes. Next, oxygen plasma treatment was performed for 5 minutes to remove the curable resin composition and its cured product remaining on the via surface.

### (Comparative Example 9)

A glass substrate with a metal sintered body was prepared in the same manner as described above, except that a glass substrate (via diameter: 90 µm) and the metal paste of Preparation Example J were used, and the porosity was measured. Note that the concentrations (mass%) of the metal particles in the metal paste part before and after drying were 94.7 mass% and 96.0 mass%, respectively.

A wiring board was obtained and evaluated in the same manner as in Example 1, except that the glass substrate with a metal sintered body prepared above was used.

### [Impregnation Depth of Photosensitive Resin Composition into Porous Part of Metal Sintered Body]

The cross section of the conductive via of the glass substrate with conductive vias was exposed by cross section polishing, the surface was cleaned by ion milling, and the cross section was observed. Using a scanning electron microscope S-3700N (manufactured by Hitachi High-Technologies Corporation), the impregnation depth of the photosensitive resin composition (or its cured product) into the porous part was measured. The distance from the via surface to the porous (void) part was measured at 10 points, and the average value was taken as the impregnation depth.

### [Evaluation of Wiring Board]

For the test pieces obtained above, the initial resistance values, the connection reliabilities, and the recesses on the surface of the wiring pattern formed on the conductive vias were evaluated according to the following methods.

### <Initial Resistance Value>

As the initial resistance value of the test piece 55 (wiring board), the resistance value of 1,000 connected vias was measured. Based on this connection resistance value, the initial resistance value was evaluated according to the following criteria.

### (Number of Vias)

1,000

### (Criteria)

A: The resistance value is less than 6 Ω
B: The resistance value is 6 Ω or more and less than 10 Ω
C: The resistance value is 10 Ω or more and less than 20 Ω
D: The resistance value is 20 Ω or more and less than 50 Ω
E: The resistance value is 50 Ω or more

### <Connection Reliability - Temperature Cycle Test>

The test piece 55 (wiring board) was set in a temperature cycle tester (TSA-72SE-W, manufactured by ESPEC CORP.), and a temperature cycle connection reliability test was performed under the conditions of low temperature: -55°C, 15 minutes, room temperature: 2 minutes, high temperature: 125°C, 15 minutes, defrosting cycle: automatic, and number of cycles: 50, 100, 300, 500, and 1,000 cycles. For the test piece subjected to each number of cycles, the resistance value of the above number of interconnected vias was measured. The connection reliability was evaluated based on this connection resistance value according to the following criteria.

### (Criteria)

A: The resistance change rate is less than 1% with respect to the initial resistance value
B: The resistance change rate is 1% or more and less than 3% with respect to the initial resistance value
C: The resistance change rate is 3% or more and less than 5% with respect to the initial resistance value
D: The resistance change rate is 5% or more and less than 10% with respect to the initial resistance value
E: The resistance change rate is 10% or more and less than 20% with respect to the initial resistance value
F: The resistance change rate is 20% or more with respect to the initial resistance value
G: Conduction failure occurred

### <Connection Reliability - 150°C>

The test piece 55 was set in a high-temperature chamber (precision constant temperature oven DH612, manufactured by Yamato Scientific Co., Ltd.) and left at 150°C for 50, 100, 300, and 500 hours to perform a high-temperature storage test. For the test piece subjected to each time period, the resistance value of the above number of connected vias was measured. The connection reliability was evaluated based on the connection resistance value according to the following criteria.

### (Criteria)

A: The resistance change rate is less than 1% with respect to the initial resistance value
B: The resistance change rate is 1% or more and less than 3% with respect to the initial resistance value
C: The resistance change rate is 3% or more and less than 5% with respect to the initial resistance value
D: The resistance change rate is 5% or more and less than 10% with respect to the initial resistance value
E: The resistance change rate is 10% or more and less than 20% with respect to the initial resistance value
F: The resistance change rate is 20% or more with respect to the initial resistance value
G: Conduction failure occurred

### <Connection Reliability - 200°C>

The test piece 55 was set in a high-temperature chamber (precision constant temperature oven DH612, manufactured by Yamato Scientific Co., Ltd.) and left at 200°C for 50, 100, 300, and 500 hours to perform a high-temperature storage test. For the test piece subjected to each time period, the resistance value of the above number of connected vias was measured. The connection reliability was evaluated based on the connection resistance value according to the following criteria.

### (Criteria)

A: The resistance change rate is less than 1% with respect to the initial resistance value
B: The resistance change rate is 1% or more and less than 3% with respect to the initial resistance value
C: The resistance change rate is 3% or more and less than 5% with respect to the initial resistance value
D: The resistance change rate is 5% or more and less than 10% with respect to the initial resistance value
E: The resistance change rate is 10% or more and less than 20% with respect to the initial resistance value
F: The resistance change rate is 20% or more with respect to the initial resistance value
G: Conduction failure occurred

### <Recesses on Surface of Wiring Pattern Formed on Conductive Vias>

The surface of the wiring pattern formed on the conductive vias of the test piece 55 (wiring board) was observed for 30 conductive vias using a digital microscope (VHX-6000, manufactured by KEYENCE CORPORATION), the deepest point was measured, and the average value was taken as the recess(es) on the wiring pattern surface.

### (Criteria)

A: The mean value of the average step height is less than 2 µm
B: The mean value of the average step height is 2 µm or more and less than 4 µm
C: The mean value of the average step height is 4 µm or more and less than 6 µm
D: The mean value of the average step height is 6 µm or more and less than 8 µm
E: The mean value of the average step height is 8 µm or more

**[Table 3]**

| | | | Example 1 | Example 2 | Example 3 | Example 4 | Example 5 | Example 6 | Example 7 | Example 8 |
|---|---|---|---|---|---|---|---|---|---|---|
| Metal Paste | | | Preparation Example A | Preparation Example A | Preparation Example A | Preparation Example A | Preparation Example A | Preparation Example A | Preparation Example A | Preparation Example A |
| Substrate | | Material | Glass | Glass | Glass | Glass | Glass | Glass | Glass | Glass |
| | | Type of hole | Through | Through | Through | Through | Through | Through | Through | Through |
| | | Via diameter (µm) | 50 | 90 | 150 | 200 | 50 | 90 | 150 | 200 |
| | | Via depth (µm) | 300 | 300 | 300 | 300 | 300 | 300 | 300 | 300 |
| Porosity of metal sintered body (%) | | | 4 | 4 | 4 | 4 | 4 | 4 | 4 | 4 |
| Photosensitive resin composition | | | F1 | F1 | F1 | F1 | F1 | F1 | F1 | F1 |
| Impregnation depth of photosensitive resin composition into metal sintered body (µm) | | | 2 | 2 | 2 | 2 | 4 | 4 | 4 | 4 |
| Wiring board | Recesses on surface of wiring pattern formed on conductive vias (µm) | | A | A | A | A | A | A | A | A |
| | Initial resistance value | | A | A | A | A | A | A | A | A |
| | After reliability test (temperature cycle) | 50 cycles | A | A | B | B | A | A | A | A |
| | | 100 cycles | A | A | B | B | A | A | A | A |
| | | 300 cycles | A | A | B | B | A | A | A | B |
| | | 500 cycles | A | A | B | B | A | A | A | B |
| | | 1000 cycles | A | A | B | B | A | A | A | B |
| | After reliability test (150°C) | 50 hours | A | A | B | B | A | A | A | B |
| | | 100 hours | A | A | B | B | A | A | A | B |
| | | 300 hours | B | B | C | C | B | B | B | B |
| | | 500 hours | B | B | C | C | B | B | B | B |
| | After reliability test (200°C) | 50 hours | A | A | B | B | A | A | A | B |
| | | 100 hours | A | A | B | B | A | A | A | B |
| | | 300 hours | B | B | C | C | B | B | B | B |
| | | 500 hours | B | B | C | C | B | B | B | B |

**[Table 4]**

| | | | Example 9 | Example 10 | Example 11 | Example 12 | Example 13 | Example 14 | Example 15 | Example 16 |
|---|---|---|---|---|---|---|---|---|---|---|
| Metal Paste | | | Preparation Example A | Preparation Example A | Preparation Example A | Preparation Example A | Preparation Example A | Preparation Example A | Preparation Example A | Preparation Example A |
| Substrate | | Material | Glass | Glass | Glass | Glass | Glass | Glass | Glass | Glass |
| | | Type of hole | Through | Through | Through | Through | Through | Through | Through | Through |
| | | Via diameter (µm) | 50 | 90 | 150 | 200 | 50 | 90 | 150 | 200 |
| | | Via depth (µm) | 300 | 300 | 300 | 300 | 300 | 300 | 300 | 300 |
| Porosity of metal sintered body (%) | | | 4 | 4 | 4 | 4 | 4 | 4 | 4 | 4 |
| Photosensitive resin composition | | | F1 | F1 | F1 | F1 | F2 | F2 | F2 | F2 |
| Impregnation depth of photosensitive resin composition into metal sintered body (µm) | | | 7 | 7 | 7 | 7 | 7 | 7 | 7 | 7 |
| Wiring board | Recesses on surface of wiring pattern formed on conductive vias (µm) | | A | A | A | A | A | A | A | A |
| | Initial resistance value | | A | A | A | A | A | A | A | A |
| | After reliability test (temperature cycle) | 50 cycles | A | A | A | A | A | A | A | A |
| | | 100 cycles | A | A | A | A | A | A | A | A |
| | | 300 cycles | A | A | A | A | A | A | A | A |
| | | 500 cycles | A | A | A | A | A | A | A | A |
| | | 1000 cycles | A | A | A | A | A | A | A | A |
| | After reliability test (150°C) | 50 hours | A | A | A | A | A | A | A | A |
| | | 100 hours | A | A | A | A | A | A | A | A |
| | | 300 hours | B | B | B | B | A | A | A | A |
| | | 500 hours | B | B | B | B | A | A | A | A |
| | After reliability test (200°C) | 50 hours | A | A | A | A | A | A | A | A |
| | | 100 hours | A | A | A | A | A | A | A | A |
| | | 300 hours | B | B | B | B | B | B | B | B |
| | | 500 hours | B | B | B | B | B | B | B | B |

**[Table 5]**

| | | | Example 17 | Example 18 | Example 19 | Example 20 | Example 21 | Example 22 | Example 23 | Example 24 |
|---|---|---|---|---|---|---|---|---|---|---|
| Metal Paste | | | Preparation Example A | Preparation Example A | Preparation Example A | Preparation Example A | Preparation Example A | Preparation Example A | Preparation Example A | Preparation Example A |
| Substrate | | Material | Glass | Glass | Glass | Glass | Glass | Glass | Glass | Glass |
| | | Type of hole | Through | Through | Through | Through | Through | Through | Through | Through |
| | | Via diameter (µm) | 50 | 90 | 150 | 200 | 50 | 90 | 150 | 200 |
| | | Via depth (µm) | 300 | 300 | 300 | 300 | 300 | 300 | 300 | 300 |
| Porosity of metal sintered body (%) | | | 4 | 4 | 4 | 4 | 4 | 4 | 4 | 4 |
| Photosensitive resin composition | | | F3 | F3 | F3 | F3 | L1 | L1 | L1 | L1 |
| Impregnation depth of photosensitive resin composition into metal sintered body (µm) | | | 14 | 14 | 14 | 14 | 50 | 50 | 50 | 50 |
| Wiring board | Recesses on surface of wiring pattern formed on conductive vias (µm) | | A | A | A | A | A | A | A | A |
| | Initial resistance value | | A | A | A | A | A | A | A | A |
| | After reliability test (temperature cycle) | 50 cycles | A | A | A | A | A | A | A | A |
| | | 100 cycles | A | A | A | A | A | A | A | A |
| | | 300 cycles | A | A | A | A | A | A | A | A |
| | | 500 cycles | A | A | A | A | A | A | A | A |
| | | 1000 cycles | A | A | A | A | A | A | A | A |
| | After reliability test (150°C) | 50 hours | A | A | A | A | A | A | A | A |
| | | 100 hours | A | A | A | A | A | A | A | A |
| | | 300 hours | A | A | A | A | A | A | A | A |
| | | 500 hours | A | A | A | A | A | A | A | A |
| | After reliability test (200°C) | 50 hours | A | A | A | A | A | A | A | A |
| | | 100 hours | A | A | A | A | A | A | A | A |
| | | 300 hours | B | B | B | B | B | B | B | B |
| | | 500 hours | B | B | B | B | B | B | B | B |

**[Table 6]**

| | | | Example 25 | Example 26 | Example 27 | Example 28 | Example 29 | Example 30 | Example 31 | Example 32 |
|---|---|---|---|---|---|---|---|---|---|---|
| Metal Paste | | | Preparation Example A | Preparation Example A | Preparation Example A | Preparation Example A | Preparation Example A | Preparation Example A | Preparation Example A | Preparation Example A |
| Substrate | | Material | Glass | Glass | Glass | Glass | Glass | Glass | Glass | Glass |
| | | Type of hole | Through | Through | Through | Through | Through | Through | Through | Through |
| | | Via diameter (µm) | 50 | 90 | 150 | 200 | 50 | 90 | 150 | 200 |
| | | Via depth (µm) | 300 | 300 | 300 | 300 | 300 | 300 | 300 | 300 |
| Porosity of metal sintered body (%) | | | 4 | 4 | 4 | 4 | 4 | 4 | 4 | 4 |
| Photosensitive resin composition | | | L2 | L2 | L2 | L2 | L2 | L2 | L2 | L2 |
| Impregnation depth of photosensitive resin composition into metal sintered body (µm) | | | 50 | 50 | 50 | 50 | Fully impregnated | Fully impregnate | Fully impregnate | Fully impregnate |
| Wiring board | Recesses on surface of wiring pattern formed on conductive vias (µm) | | A | A | A | A | A | A | A | A |
| | Initial resistance value | | A | A | A | A | A | A | A | A |
| | After reliability test (temperature cycle) | 50 cycles | A | A | A | A | A | A | A | A |
| | | 100 cycles | A | A | A | A | A | A | A | A |
| | | 300 cycles | A | A | A | A | A | A | A | A |
| | | 500 cycles | A | A | A | A | A | A | A | A |
| | | 1000 cycles | A | A | A | A | A | A | A | A |
| | After reliability test (150°C) | 50 hours | A | A | A | A | A | A | A | A |
| | | 100 hours | A | A | A | A | A | A | A | A |
| | | 300 hours | A | A | A | A | A | A | A | A |
| | | 500 hours | A | A | A | A | A | A | A | A |
| | After reliability test (200°C) | 50 hours | A | A | A | A | A | A | A | A |
| | | 100 hours | A | A | A | A | A | A | A | A |
| | | 300 hours | B | B | B | B | A | A | A | A |
| | | 500 hours | B | B | B | B | A | A | A | A |

**[Table 7]**

| | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|---|
| Metal Paste | | | Preparation Example A | Preparation Example A | Preparation Example A | Preparation Example A | Preparation Example A | Preparation Example A | Preparation Example A | Preparation Example A | Preparation Example J |
| Substrate | | Material | Glass | Glass | Glass | Glass | Glass | Glass | Glass | Glass | Glass |
| | | Type of hole | Through | Through | Through | Through | Through | Through | Through | Through | Through |
| | | Via diameter (µm) | 50 | 90 | 150 | 200 | 50 | 90 | 150 | 200 | 90 |
| | | Via depth (µm) | 300 | 300 | 300 | 300 | 300 | 300 | 300 | 300 | 300 |
| Porosity of metal sintered body (%) | | | 4 | 4 | 4 | 4 | 4 | 4 | 4 | 4 | 8 |
| Photosensitive resin composition | | | F1 | F1 | F1 | F1 | -^{*1} | -^{*1} | -^{*1} | -^{*1} | - |
| Impregnation depth of photosensitive resin composition into metal sintered body (µm) | | | 0 | 0 | 0 | 0 | -^{*1} | -^{*1} | -^{*1} | -^{*1} | - |
| Wiring board | Recesses on surface of wiring pattern formed on conductive vias (µm) | | A | A | A | A | C | C | D | E | C |
| | Initial resistance value | | B | B | B | B | A | A | A | A | E |
| | After reliability test (temperature cycle) | 50 cycles | C | C | C | C | A | A | B | B | A |
| | | 100 cycles | C | C | C | C | A | A | B | B | A |
| | | 300 cycles | C | C | C | C | B | B | B | B | A |
| | | 500 cycles | C | C | C | C | B | B | C | C | A |
| | | 1000 cycles | C | C | C | C | C | C | C | D | A |
| | After reliability test (150°C) | 50 hours | C | C | C | C | B | B | B | B | A |
| | | 100 hours | C | C | C | C | B | B | B | B | A |
| | | 300 hours | C | C | C | C | C | C | C | C | B |
| | | 500 hours | C | C | C | C | C | C | D | D | B |
| | After reliability test (200°C) | 50 hours | C | C | C | C | B | B | B | C | C |
| | | 100 hours | C | C | C | C | C | C | C | D | C |
| | | 300 hours | D | D | D | D | D | D | E | F | D |
| | | 500 hours | E | E | E | E | E | G | G | G | D |

| | | | | | | | | | | | |
|---|---|---|---|---|---|---|---|---|---|---|---|
| *1: Fully impregnated with a thermosetting resin. | | | | | | | | | | | |

### (Examples 33 to 43)

A glass substrate with a metal sintered body was prepared and the porosity was measured in the same manner as in Examples 1 to 4, except that the metal paste of Preparation Example B was used. Note that the concentrations (mass%) of the metal particles in the metal paste part before and after drying were 95.7 mass% and 97.8 mass%, respectively.

Wiring boards were obtained and evaluated in the same manner as in Examples 1 to 4, except that the glass substrate with a metal sintered body prepared above was used.

### (Example 37)

A glass substrate with a metal sintered body was prepared in the same manner as in Example 3, except that the metal paste of Preparation Example C was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used and the roll pressure of the dry film "RD-1619" was changed to 3 MPa.

### (Example 38)

A glass substrate with a metal sintered body was prepared in the same manner as in Example 3, except that the metal paste of Preparation Example D was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used and the roll pressure of the dry film "RD-1619" was changed to 3 MPa.

### (Example 39)

A glass substrate with a metal sintered body was prepared in the same manner as in Example 3, except that the metal paste of Preparation Example E was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used.

### (Example 40)

A glass substrate with a metal sintered body was prepared in the same manner as in Example 3, except that the metal paste of Preparation Example F was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used.

### (Example 41)

A glass substrate in which the metal sintered body precursor was formed in the through-holes was obtained in the same manner as in Example 3, except that the metal paste of Preparation Example G was used. Next, the glass substrate was disposed in a tube furnace (manufactured by AVC Co., LTD.), the temperature was raised to 300°C over 10 minutes in the air, and the metal sintered body precursor was sintered by performing a sintering treatment at 300°C for 60 minutes. Thereafter, the resulting product was cooled by flowing argon gas at a flow rate of 0.3 L/min and taken out into the air at 50°C or lower, thereby obtaining a glass substrate with a metal sintered body. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used.

### (Example 42)

A glass substrate with a metal sintered body was prepared in the same manner as in Example 3, except that the metal paste of Preparation Example H was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used.

### (Example 43)

A glass substrate with a metal sintered body was prepared in the same manner as in Example 3, except that the metal paste of Preparation Example I was used, and the porosity was measured. Note that the concentrations (mass%) of the metal particles in the metal paste part before and after drying were 95.7 mass% and 97.8 mass%, respectively.

A wiring board was obtained and evaluated in the same manner as in Example 3, except that the glass substrate with a metal sintered body prepared above was used.

### (Comparative Example 10)

A glass substrate with a metal sintered body was prepared in the same manner as in Example 41.

A wiring board was obtained and evaluated in the same manner as in Example 3, except that the glass substrate with a metal sintered body prepared above was used, the roll pressure of the dry film "RD-1619" was changed to 0.1 MPa, and the treatment time in the etching treatment was changed to 5 minutes.

**[Table 8]**

| | | | Example 33 | Example 34 | Example 35 | Example 36 | Example 37 | Example 38 | Example 39 | Example 40 |
|---|---|---|---|---|---|---|---|---|---|---|
| Metal Paste | | | Preparation Example B | Preparation Example B | Preparation Example B | Preparation Example B | Preparation Example C | Preparation Example D | Preparation Example E | Preparation Example F |
| Substrate | | Material | Glass | Glass | Glass | Glass | Glass | Glass | Glass | Glass |
| | | Type of hole | Through | Through | Through | Through | Through | Through | Through | Through |
| | | Via diameter (µm) | 50 | 90 | 150 | 200 | 150 | 150 | 150 | 150 |
| | | Via depth (µm) | 300 | 300 | 300 | 300 | 300 | 300 | 300 | 300 |
| Porosity of metal sintered body (%) | | | 10 | 10 | 10 | 10 | 6 | 6 | 4 | 4 |
| Photosensitive resin composition | | | F1 | F1 | F1 | F1 | F1 | F1 | F1 | F1 |
| Impregnation depth of photosensitive resin composition into metal sintered body (µm) | | | 7 | 7 | 7 | 7 | 7 | 7 | 2 | 2 |
| Wiring board | Recesses on surface of wiring pattern formed on conductive vias (µm) | | A | A | A | A | A | A | A | A |
| | Initial resistance value | | A | A | A | A | B | B | B | B |
| | After reliability test (temperature cycle) | 50 cycles | A | A | A | A | A | A | A | A |
| | | 100 cycles | A | A | A | A | A | A | A | A |
| | | 300 cycles | A | A | A | A | A | A | A | A |
| | | 500 cycles | A | A | A | A | A | A | A | A |
| | | 1000 cycles | A | A | A | A | A | A | A | A |
| | After reliability test (150°C) | 50 hours | A | A | A | A | A | A | A | A |
| | | 100 hours | A | A | A | A | A | A | A | A |
| | | 300 hours | B | B | B | B | B | B | B | B |
| | | 500 hours | B | B | B | B | B | B | B | B |
| | After reliability test (200°C) | 50 hours | A | A | A | A | A | A | A | A |
| | | 100 hours | A | A | A | A | A | A | A | A |
| | | 300 hours | B | B | B | B | B | B | B | B |
| | | 500 hours | B | B | B | B | B | B | B | B |

**[Table 9]**

| | | | Example 41 | Example 42 | Example 43 | Comparative Example 10 |
|---|---|---|---|---|---|---|
| Metal Paste | | | Preparation Example G | Preparation Example H | Preparation Example I | Preparation Example G |
| Substrate | | Material | Glass | Glass | Glass | Glass |
| | | Type of hole | Through | Through | Through | Through |
| | | Via diameter (µm) | 150 | 150 | 150 | 150 |
| | | Via depth (µm) | 300 | 300 | 300 | 300 |
| Porosity of metal sintered body (%) | | | 4 | 4 | 4 | 4 |
| Photosensitive resin composition | | | F1 | F1 | F1 | F1 |
| Impregnation depth of photosensitive resin composition into metal sintered body (µm) | | | 2 | 2 | 2 | 0 |
| Wiring board | Recesses on surface of wiring pattern formed on conductive vias (µm) | | A | A | A | A |
| | Initial resistance value | | A | A | A | B |
| | After reliability test (temperature cycle) | 50 cycles | A | A | A | C |
| | | 100 cycles | A | A | A | C |
| | | 300 cycles | A | A | A | C |
| | | 500 cycles | A | A | A | C |
| | | 1000 cycles | A | A | A | C |
| | After reliability test (150°C) | 50 hours | A | B | A | C |
| | | 100 hours | A | B | B | C |
| | | 300 hours | A | B | B | C |
| | | 500 hours | B | C | C | C |
| | After reliability test (200°C) | 50 hours | A | A | A | C |
| | | 100 hours | A | B | A | C |
| | | 300 hours | A | B | B | D |
| | | 500 hours | B | C | C | E |

### [Production of Silicon Substrate with Conductive Vias]

### (Examples 44 to 47)

Silicon substrates with conductive vias were produced by the following procedure.

### <Preparation of Silicon Substrate>

A silicon substrate provided with through-holes and having a titanium layer, a nickel layer, and a copper layer formed in this order on both main surfaces and on the wall surfaces of the through-holes was prepared. Note that the silicon substrate has a diameter of 6 inches and a thickness of 300 µm, the titanium layer, the nickel layer, and the copper layer are sequentially formed by sputtering, and substrates provided with through-holes having hole diameters (via diameters) of 50, 90, 150, and 200 µm were prepared, respectively.

### <Preparation of Metal Particle Film>

The metal paste of Preparation Example A prepared above was printed on a PET film having a thickness of 100 µm with a screen printer in a size of 8 inch-Ø (circular shape with a diameter of 20 cm) using a screen printing plate (wire diameter: 23 µm, number of meshes: 400, mesh size: 41 µm, space ratio: 41 µm) to obtain a metal particle film provided with a metal particle-containing layer.

### <Formation of Metal Sintered Body>

Using a bonding apparatus VJ-35 (manufactured by Ayumi Industry Co., Ltd.), the metal particle film was bonded to the silicon substrate from the metal particle-containing layer side, and the laminate was further vacuum-pressed at room temperature at a pressure of 3 MPa to fill the through-holes with the metal paste. At this time, the metal paste was caused to protrude on the side of the silicon substrate opposite to the side on which the metal particle film was bonded.

Next, the laminate from which the PET film had been peeled off was dried in the air at 90°C for 10 minutes. Note that the concentrations (mass%) of the metal particles in the metal paste part before and after drying were 95.7 mass% and 97.8 mass%, respectively.

For the laminate after drying, as illustrated in FIGS. 3(a) to 3(d), the metal paste on the main surface of the silicon substrate on the side to which the metal particle film was bonded was removed using a rubber squeegee, and subsequently, the metal paste protruding on the side of the silicon substrate opposite to the side to which the metal particle film was bonded was removed using a rubber squeegee.

Next, the silicon substrate in which the metal sintered body precursor was formed in the through-holes by the process described above was disposed in a tube furnace (manufactured by AVC Co., LTD.), and an argon gas was caused to flow at 1 L/min to replace the air in the tube furnace with the argon gas. Thereafter, the temperature was increased to 300°C over 10 minutes while flowing a hydrogen gas at 300 mL/min, and a sintering treatment was performed at 300°C for 60 minutes to sinter the metal sintered body precursor. Thereafter, the resulting product was cooled by flowing an argon gas at a flow rate of 0.3 L/min and taken out into the air at 50°C or lower, thereby obtaining a silicon substrate with a metal sintered body.

For the silicon substrate with a metal sintered body obtained above, the porosity of the metal sintered body was evaluated in accordance with the above-described method.

Wiring boards were obtained and evaluated in the same manner as in Examples 1 to 4, except that the silicon substrate with a metal sintered body obtained above was used and the roll pressure of the dry film "RD-1619" was changed to 3 MPa.

### [Production of Organic Substrate with Conductive Vias]

### (Examples 48 to 50)

Organic substrates with conductive vias were produced by the following procedure.

### <Preparation of Organic Substrate>

A high-Tg glass epoxy multilayer material MCL-E-679F(J) (manufactured by Resonac Corporation) having a board thickness of 300 µm with 1 µm copper foil bonded on both surfaces was prepared, and through-holes having hole diameters (via diameters) of 90, 150, and 200 µm were provided. A copper plating film having a thickness of 0.5 µm was formed inside the vias by electroless copper plating.

Using the organic substrate described above, an organic substrate with a metal sintered body was obtained in the same manner as the method for producing the silicon substrate with a metal sintered body described above, except that the temperature was raised to 225°C over 10 minutes and a sintering treatment was performed at 225°C for 60 minutes. The porosity of the metal sintered body of the obtained organic substrate with a metal sintered body was evaluated in accordance with the above-described method.

Wiring boards were obtained and evaluated in the same manner as in Examples 2 to 4, except that the organic substrate with a metal sintered body obtained above was used and the roll pressure of the dry film "RD-1619" was changed to 3 MPa.

**[Table 10]**

| | | | Example 44 | Example 45 | Example 46 | Example 47 | Example 48 | Example 49 | Example 50 |
|---|---|---|---|---|---|---|---|---|---|
| Metal Paste | | | Preparation Example A | Preparation Example A | Preparation Example A | Preparation Example A | Preparation Example A | Preparation Example A | Preparation Example A |
| Substrate | | Material | Silicon | Silicon | Silicon | Silicon | Organic substrate | Organic substrate | Organic substrate |
| | | Type of hole | Through | Through | Through | Through | Through | Through | Through |
| | | Via diameter (µm) | 50 | 90 | 150 | 200 | 90 | 150 | 200 |
| | | Via depth (µm) | 300 | 300 | 300 | 300 | 300 | 300 | 300 |
| Porosity of metal sintered body (%) | | | 4 | 4 | 4 | 4 | 4 | 4 | 4 |
| Photosensitive resin composition | | | F1 | F1 | F1 | F1 | F1 | F1 | F1 |
| Impregnation depth of photosensitive resin composition into metal sintered body (µm) | | | 7 | 7 | 7 | 7 | 7 | 7 | 7 |
| Wiring board | Recesses on surface of wiring pattern formed on conductive vias (µm) | | A | A | A | A | A | A | A |
| | Initial resistance value | | A | A | A | A | B | B | B |
| | After reliability test (temperature cycle) | 50 cycles | A | A | A | A | A | A | A |
| | | 100 cycles | A | A | A | A | A | A | A |
| | | 300 cycles | A | A | A | A | A | A | A |
| | | 500 cycles | A | A | A | A | A | A | A |
| | | 1000 cycles | A | A | A | A | A | A | A |
| | After reliability test (150°C) | 50 hours | A | A | A | A | A | A | A |
| | | 100 hours | A | A | A | A | A | A | A |
| | | 300 hours | A | A | A | A | A | A | A |
| | | 500 hours | B | B | B | B | B | B | B |
| | After reliability test (200°C) | 50 hours | A | A | A | A | A | A | A |
| | | 100 hours | A | A | A | A | A | A | A |
| | | 300 hours | A | A | A | A | A | A | A |
| | | 500 hours | B | B | B | B | B | B | B |

It was confirmed that the substrates with conductive vias of the Examples can provide a wiring board that exhibits a sufficiently low connection resistance value and has excellent connection reliability.

In addition, for the wiring boards produced in Examples 1 and 29, the cross section of the central part of the conductive via was exposed by a focused ion beam using a focused ion beam machining observation device (trade name: MI4050, manufactured by Hitachi High-Technologies Corporation), and the cross section was observed, whereby the following findings were obtained.

In the wiring board produced in Example 1, the photosensitive resin composition was not impregnated into the central part of the conductive via, and gaps were observed between the copper particles, but no deterioration or the like due to penetration of an aqueous solution or the like used in the formation of the electrolytic copper plating film was observed. In addition, in the wiring board prepared in Example 29, the photosensitive resin composition was impregnated even into the central part of the conductive via, and no gaps were observed between the copper particles.

As described above, it is considered that the substrates with conductive vias of the Examples could achieve both good wiring formation and suppression of penetration of aqueous solutions and the like by impregnating the metal sintered body with the photosensitive resin composition, which allowed the resin composition on the surface of the metal sintered body to be removed by a development treatment while leaving the resin composition in the metal sintered body.

### Reference Signs List

- 1: Silicon wafer
- 2: Metal coating
- 3: Metal paste part
- 3b: Metal sintered body precursor
- 3c: Conductive via
- 3p: Metal particle-containing layer
- 7: Support film
- 8a: Etching resist
- 9: Wiring
- 30: Through-hole
- 31: Blind- hole
- 32: Porous structure
- 34a, 34b, 34c: Resin composition
- 40, 41: Silicon substrate
- 42: Rubber squeegee
- 50: Substrate with conductive vias
- 52: Wiring board with conductive vias
- 55: Test piece
- 80, 82, 84: Photosensitive resin composition
- A: Pressure jig

## Claims

1. A method for manufacturing a substrate with conductive vias, the method comprising:
step S1 of preparing a substrate with a metal sintered body, the substrate comprising a substrate having holes opening on one or both main surfaces and a metal sintered body having a porous structure provided inside the holes, the metal sintered body being exposed at the openings of the holes; and
step S2 of providing the metal sintered body with a resin-containing part containing a photosensitive resin composition or a cured product thereof.

2. The method for manufacturing a substrate with conductive vias according to claim 1, wherein in step S2, the metal sintered body is provided with the resin-containing part and a resin-free part not containing a resin composition or a cured product thereof such that the resin-containing part is localized on the opening side.

3. The method for manufacturing a substrate with conductive vias according to claim 1, wherein step S2 comprises:
step S2-1a of impregnating at least a part of the metal sintered body with a negative-type photosensitive resin composition by laminating a film-shaped negative-type photosensitive resin composition onto a surface of the substrate with a metal sintered body; and
step S2-2a of, after step S2-1a, removing the film-shaped negative-type photosensitive resin composition by a development treatment to expose the metal sintered body having the resin-containing part containing the negative-type photosensitive resin composition at the openings of the holes.

4. The method for manufacturing a substrate with conductive vias according to claim 3, wherein step S2 further comprises step S2-3a of curing the negative-type photosensitive resin composition contained in the resin-containing part after step S2-2a.

5. The method for manufacturing a substrate with conductive vias according to claim 4, wherein step S2 further comprises step S2-4a of performing a desmear treatment on at least the exposed surface of the metal sintered body after step S2-3a.

6. The method for manufacturing a substrate with conductive vias according to claim 1, wherein step S2 includes:
step S2-1b of impregnating at least a part of the metal sintered body with a negative-type photosensitive resin composition by applying a liquid negative-type photosensitive resin composition onto a surface of the substrate with a metal sintered body; and
step S2-2b of, after step S2-1b, removing the coating film of the liquid negative-type photosensitive resin composition by a development treatment to expose the metal sintered body having the resin-containing part containing the negative-type photosensitive resin composition at the openings of the holes.

7. The method for manufacturing a substrate with conductive vias according to claim 6, wherein step S2 further comprises step S2-3b of curing the negative-type photosensitive resin composition contained in the resin-containing part after step S2-2b.

8. The method for manufacturing a substrate with conductive vias according to claim 7, wherein step S2 further comprises step S2-4b of performing a desmear treatment on at least the exposed surface of the metal sintered body after step S2-3b.

9. The method for manufacturing a substrate with conductive vias according to claim 1, wherein step S2 comprises:
step S2-1c of impregnating at least a part of the metal sintered body with a positive-type photosensitive resin composition by applying a liquid positive-type photosensitive resin composition onto a surface of the substrate with a metal sintered body or by laminating a film-shaped positive-type photosensitive resin composition onto a surface of the substrate with a metal sintered body; and
step S2-2c of, after step S2-1c, removing the coating film of the liquid positive-type photosensitive resin composition or the film-shaped positive-type photosensitive resin composition by exposure and a development treatment to expose the metal sintered body having the resin-containing part containing the positive-type photosensitive resin composition at the openings of the holes.

10. The method for manufacturing a substrate with conductive vias according to claim 9, wherein the positive-type photosensitive resin composition contains a thermosetting component, and step S2 further comprises step S2-3c of thermally curing the positive-type photosensitive resin composition contained in the resin-containing part after step S2-2c.

11. The method for manufacturing a substrate with conductive vias according to claim 10, wherein step S2 further comprises step S2-4c of performing a desmear treatment on at least the exposed surface of the metal sintered body after step S2-3c.

12. A method for manufacturing a wiring board with conductive vias, the method comprising:
step S3 of forming a wiring electrically connected to the conductive vias on the substrate with conductive vias obtained by the method according to any one of claims 1 to 11.

13. A substrate with conductive vias, comprising a substrate having through-holes and conductive vias provided in the through-holes,
wherein the conductive vias comprise a metal sintered body having a porous structure, and
the metal sintered body comprises a resin-containing part containing a photosensitive resin composition or a cured product thereof.

14. The substrate with conductive vias according to claim 13, wherein the metal sintered body further comprises a resin-free part not containing a resin composition or a cured product thereof, and the resin-containing part is localized on an opening side of the through-holes in the metal sintered body.

15. A wiring board with conductive vias, comprising the substrate with conductive vias according to claim 13 or 14 and a wiring provided on the substrate with conductive vias and electrically connected to the conductive vias.
